# EUROPEAN PATENT APPLICATION

(11) **EP 4 432 809 A1**
(43) Date of publication of application: **18.09.2024**
(21) Application number: 24157644.6
(22) Date of filing: 14.02.2024
(51) Int. Cl.: H10K 59/122, H10K 59/123

(54) **DISPLAY DEVICE AND METHOD OF MANUFACTURING THE SAME**

(30) Priority: 15.02.2023 KR 20230019850
(71) Applicant: Samsung Display Co., Ltd., Yongin-si, Gyeonggi-do 17113 (KR)
(72) Inventor: LEE, Dong-Hoon, 17113 Yongin-si (KR); KIM, Hyunjoon, 17113 Yongin-si (KR); KIM, Haemin, 17113 Yongin-si (KR); SEO, Youngwan, 17113 Yongin-si (KR); LEE, Geunho, 17113 Yongin-si (KR); LEE, Sunhwa, 17113 Yongin-si (KR)
(74) Representative: Walaski, Jan Filip

(57) **Abstract**

A display device (DP) includes a first light emitting element (LD1), a second light emitting element (LD2), and a barrier wall conductive layer (WCL) disposed between the first light emitting element (LD1) and the second light emitting element (LD2) and electrically connected to the first light emitting element (LD1) and the second light emitting element (LD2). A barrier wall opening (WOP) is formed through the barrier wall conductive layer (WCL), and the barrier wall opening (WOP) is disposed between the first light emitting element (LD1) and the second light emitting element (LD2).

## Description

### CROSS REFERENCE TO RELATED APPLICATION(S)

This application claims priority to Korean Patent Application No. 10-2023-0019850, filed on February 15, 2023.

### BACKGROUND

### 1. Technical Field

Embodiments relate to a display device and a method of manufacturing the display device.

### 2. Description of the Related Art

Multimedia electronic devices, such as televisions, mobile phones, tablet computers, navigation devices, and game devices, include a display device displaying an image. The display device includes a display panel displaying the image, and the display panel includes pixels generating the image.

Each pixel includes a light emitting element and a pixel driver driving the light emitting element. Researches on a connection between the light emitting element and the pixel driver have been conducted to improve a reliability of the display panel.

A connection line is used to connect the light emitting element and the pixel driver. The connection line is connected to the light emitting element via a light emitting connection portion and is connected to the pixel driver via a driving connection portion. The light emitting connection portion is disposed to overlap the light emitting element. An aperture ratio of the pixels is reduced by the light emitting connection portion. Technology development to improve the aperture ratio of the pixels is required.

### SUMMARY

Embodiments provide a display device capable of improving an aperture ratio of pixels.

Embodiments provide a method of manufacturing the display device.

However, embodiments of the disclosure are not limited to those set forth herein. The above and other embodiments will become more apparent to one of ordinary skill in the art to which the disclosure pertains by referencing the detailed description of the disclosure given below.

In an embodiment, a display device may include a first light emitting element, a second light emitting element, and a barrier wall conductive layer disposed between the first light emitting element and the second light emitting element and electrically connected to the first light emitting element and the second light emitting element. A barrier wall opening may be formed through the barrier wall conductive layer, and the barrier wall opening may be disposed between the first light emitting element and the second light emitting element.

The first light emitting element may be electrically connected to a side surface of the barrier wall conductive layer adjacent to the first light emitting element, and the second light emitting element may be electrically connected to another side surface of the barrier wall conductive layer adjacent to the second light emitting element.

The barrier wall conductive layer may be divided into a plurality of portions by the barrier wall opening, and the first light emitting element may be electrically insulated from the second light emitting element by the plurality of portions of the barrier wall conductive layer.

The barrier wall conductive layer may include: a first barrier wall conductive layer adjacent to the first light emitting element and electrically connected to the first light emitting element; and a second barrier wall conductive layer adjacent to the second light emitting element, electrically connected to the second light emitting element, and electrically insulated from the first barrier wall conductive layer by the barrier wall opening.

The first barrier wall conductive layer may have a closed-loop shape and surrounds the first light emitting element, and the second barrier wall conductive layer may have a closed-loop shape and surrounds the second light emitting element.

The first light emitting element may be in contact with a first inner side surface of the first barrier wall conductive layer surrounding the first light emitting element, and the second light emitting element may be in contact with a second inner side surface of the second barrier wall conductive layer surrounding the second light emitting element.

The display device may further include: a transistor disposed below the first barrier wall conductive layer and electrically connected to the first barrier wall conductive layer.

The display device may further include: an insulating layer disposed between the first barrier wall conductive layer and the transistor; and a light emitting connection portion disposed in a contact hole formed through a portion of the insulating layer and overlapping the first barrier wall conductive layer in plan view, wherein the light emitting connection portion may extend from the first barrier wall conductive layer and is electrically connected to the transistor via the contact hole.

The display device may further include: a pixel definition layer in which light emitting openings are formed, wherein the first and second light emitting elements may be disposed in the light emitting openings, and the barrier wall conductive layer may be disposed on the pixel definition layer.

The pixel definition layer may include an inorganic layer.

Openings in which the first and second light emitting elements are disposed may be formed through the barrier wall conductive layer, and the openings may overlap the light emitting openings and have a size greater than those of the light emitting openings.

The barrier wall conductive layer may include: a first conductive layer disposed on the pixel definition layer; a second conductive layer disposed on the first conductive layer; and a third conductive layer disposed on the second conductive layer, and side surfaces of the first and third conductive layers adjacent to each of the first and second light emitting elements may protrude outward more than a side surface of the second conductive layer adjacent to each of the first and second light emitting elements.

The first light emitting element may include: a first electrode disposed under the pixel definition layer and partially exposed via a corresponding light emitting opening among the light emitting openings; a second electrode disposed on the first electrode; a functional layer disposed between the first electrode and the second electrode; and a light emitting layer disposed in the functional layer, and the functional layer and the second electrode may be in contact with the side surface of the second conductive layer of the barrier wall conductive layer.

The functional layer and the second electrode may be further disposed on the barrier wall conductive layer, and the barrier wall conductive layer and the second electrode may be electrically insulated from each other by the functional layer.

The display device may further include: a thin film encapsulation layer disposed on the first and second light emitting elements and the barrier wall conductive layer, wherein the barrier wall opening may be consecutively formed through the barrier wall conductive layer and the thin film encapsulation layer.

The display device may further include: a cover insulating layer disposed on the thin film encapsulation layer, wherein the cover insulating layer may be disposed in the barrier wall opening.

The display device may further include: a dummy insulating layer disposed in the barrier wall opening.

The display device may further include: a spacer disposed on the dummy insulating layer, wherein the spacer may have a width that increases as being closer to an upper surface of the spacer from a lower surface of the spacer.

The display device may further include: a thin film encapsulation layer disposed on the first and second light emitting elements and the barrier wall conductive layer, wherein the thin film encapsulation layer may be disposed in the barrier wall opening.

In an embodiment, a method of manufacturing a display device may include forming first electrodes on a base layer, forming a pixel definition layer including light emitting openings through which portions of the first electrodes are exposed, forming a barrier wall conductive layer on the first electrodes and the pixel definition layer, removing first removal portions of the barrier wall conductive layer, which overlap the light emitting openings and have a size greater than the light emitting openings, forming a functional layer, a light emitting layer disposed in the functional layer, and a second electrode disposed on the functional layer in each of the light emitting openings, forming the functional layer and the second electrode on the barrier wall conductive layer, forming a thin film encapsulation layer on the second electrodes, and forming a barrier wall opening by removing a portion of the thin film encapsulation layer overlapping a second removal portion of the barrier wall conductive layer disposed between the light emitting openings, a portion of the functional layer overlapping the second removal portion, a portion of the second electrode overlapping the second removal portion, and the second removal portion. The barrier wall conductive layer may be divided into a plurality of portions that are electrically insulated from each other by the barrier wall opening.

In an embodiment, a method of manufacturing a display device may include forming first electrodes on a base layer, forming a pixel definition layer including light emitting openings through which portions of the first electrodes are exposed, forming a barrier wall conductive layer on the pixel definition layer, removing first removal portions of the barrier wall conductive layer, which overlap the light emitting openings and have a size greater than the light emitting openings; removing a second removal portion of the barrier wall conductive layer disposed between the light emitting openings to form a barrier wall opening, forming a dummy insulating layer in the barrier wall opening, forming a spacer on the dummy insulating layer, and forming a functional layer, a light emitting layer disposed in the functional layer, and a second electrode disposed on the functional layer in each of the light emitting openings, and forming the functional layer and the second electrode on the barrier wall conductive layer and the spacer. The barrier wall conductive layer may be divided into a plurality of portions that are electrically insulated from each other by the barrier wall opening.

According to the above, a transistor of a pixel driving unit that drives the light emitting element may be connected to the light emitting element via a light emitting connection portion overlapping the barrier wall conductive layer. Since the light emitting connection portion does not overlap the light emitting element but does overlap the barrier wall conductive layer, an aperture ratio of pixels may be improved.

### BRIEF DESCRIPTION OF THE DRAWINGS

The above and other advantages of the disclosure will become readily apparent by reference to the following detailed description when considered in conjunction with the accompanying drawings wherein:
FIG. 1 is a schematic block diagram of a display device;
FIGS. 2A and 2B are schematic diagrams of equivalent circuits of pixels;
FIG. 3 is a schematic plan view of a display panel;
FIG. 4 is an enlarged schematic plan view of some areas of a display area of the display panel;
FIG. 5 is a schematic plan view of one light emitting unit shown in FIG. 4 and driving connection portions of pixel driving units connected to the light emitting unit;
FIG. 6 is a schematic plan view of a first electrode of a light emitting element shown in FIG. 4;
FIG. 7 is a schematic cross-sectional view taken along a line I-I' shown in FIG. 5;
FIG. 8 is an enlarged plan view of a first area AA1 shown in FIG. 7;
FIGS. 9A, 9B, 9C, 9D, 9E, 9F, and 9G are schematic views illustrating a method of manufacturing a display device;
FIG. 10 is a schematic view of a display device;
FIGS. 11A, 11B, 11C, 11D, 11E, 11F, and 11G are schematic views illustrating a method of manufacturing the display device shown in FIG. 10; and
FIG. 12 is a schematic view of a display device.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the X, Y, and Z - axes, and may be interpreted in a broader sense. For example, the DR1-axis, the DR2-axis, and the DR3-axis may be perpendicular to one another, or may represent different directions that are not perpendicular to one another. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, embodiments will be described with reference to the accompanying drawings.

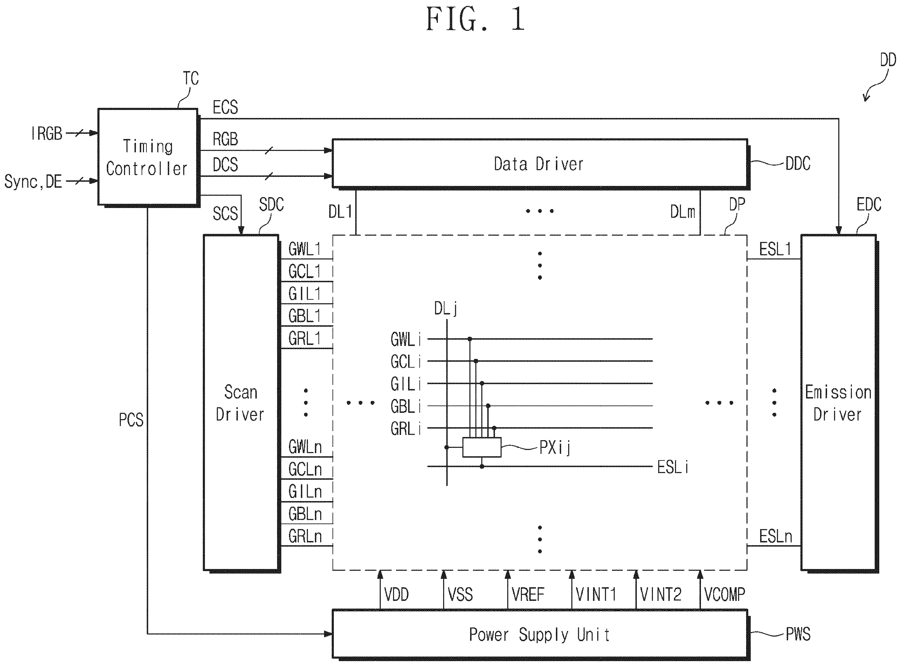

FIG. 1 is a schematic block diagram of a display device DD.

Referring to FIG. 1, the display device DD may include a display panel DP, panel drivers SDC, EDC, and DDC, a power supply unit PWS, and a timing controller TC. The panel drivers SDC, EDC, and DDC may include a scan driver SDC, an emission driver EDC, and a data driver DDC.

The display panel DP may be a light-emitting type display panel. The light-emitting type display panel may be an organic light emitting display panel, an inorganic light emitting display panel, or a quantum dot light emitting display panel. Hereinafter, the organic light emitting display panel will be described as the display panel DP.

The display panel DP may include scan lines GWL1 to GWLn, GCL1 to GCLn, GIL1 to GILn, GBL1 to GBLn, and GRL1 to GRLn, emission lines ESL1 to ESLn, and data lines DL1 to DLm. Each of "m" and "n" is an integer number greater than 1.

The display panel DP may include pixels PXij connected to the scan lines GWL1 to GWLn, GCL1 to GCLn, GIL1 to GILn, GBL1 to GBLn, and GRL1 to GRLn, the emission lines ESL1 to ESLn, and the data lines DL1 to DLm. As an example, a pixel PXij positioned to correspond to an i-th horizontal line (or an i-th pixel row) and a j-th vertical line (or a j-th pixel column) is shown in FIG. 1, however, a plurality of pixels PXij may be arranged in the display panel DP. Each of "i" and "j" is an integer number greater than 1)

The pixel PXij may be connected (e.g., electrically connected) to an i-th first scan line (or a write scan line) GWLi, an i-th second scan line (or a compensation scan line) GCLi, an i-th third scan line (or a first initialization scan line) GILi, an i-th fourth scan line (or a second initialization scan line) GBLi, an i-th fifth scan line (or a reset scan line) GRLi, a j-th data line DLj, and an i-th emission line ESLi.

The pixel PXij may include a light emitting element, transistors, and capacitors. The pixel PXij may receive a first power voltage VDD, a second power voltage VSS, a third power voltage (or a reference voltage) VREF, a fourth power voltage (or a first initialization voltage) VINT1, a fifth power voltage (or a second initialization voltage) VINT2, and a sixth power voltage (or a compensation voltage) VCOMP from the power supply unit PWS.

The light emitting element of the pixel PXij may be driven by the first power voltage VDD and the second power voltage VSS. The first power voltage VDD and the second power voltage VSS may have different voltage values so that a current flows through the light emitting element and the light emitting element emits a light. As an example, the first power voltage VDD may be set to have a voltage level higher than that of the second power voltage VSS.

The third power voltage VREF may be a voltage to initialize a gate of a driving transistor included in the pixel PXij. The fourth power voltage VINT1 may be used to initialize a capacitor included in the pixel PXij. The fifth power voltage VINT2 may be used to initialize a cathode of the light emitting element included in the pixel PXij.

The sixth power voltage VCOMP may provide a certain current to the driving transistor in case that a threshold voltage of the driving transistor is compensated for. The sixth power voltage VCOMP may be set to the same voltage level as the fifth power voltage VINT2, however, it is not limited thereto or thereby.

FIG. 1 shows a structure in which all the first, second, third, fourth, fifth, and sixth power voltages VDD, VSS, VREF, VINT1, VINT2, and VCOMP are provided from the power supply unit PWS to the display panel DP, however, implementations are not limited thereto or thereby. As an example, both of the first power voltage VDD and the second power voltage VSS may be provided to the display panel DP regardless of the structure of the pixel PXij, and at least one of the third power voltage VREF, the fourth power voltage VINT1, the fifth power voltage VINT2, and the sixth power voltage VCOMP may not be provided to the display panel DP according to the structure of the pixel PXij.

The scan driver SDC may receive a first control signal SCS from the timing controller TC and may generate scan signals in response to the first control signal SCS. The scan driver SDC may provide the scan signals to the first scan lines GWL1 to GWLn, the second scan lines GCL1 to GCLn, the third scan lines GIL1 to GILn, the fourth scan lines GBL1 to GBLn, and the fifth scan lines GRL1 to GRLn.

The scan signals may be set to a voltage level to turn on the transistors in response to the scan signals. As an example, the scan signal provided to a P-type transistor may be set to a logic low level, and the scan signal provided to an N-type transistor may be set to a logic high level. The transistors of the pixel PXij may be the N-type transistors.

FIG. 1 shows a scan driver SDC, however, implementations are not limited thereto or thereby. The display device DD may include multiple scan drivers to provide the scan signals to the first scan lines GWL1 to GWLn, the second scan lines GCL1 to GCLn, the third scan lines GIL1 to GILn, the fourth scan lines GBL1 to GBLn, and the fifth scan lines GRL1 to GRLn, respectively.

The emission driver EDC may receive a second control signal ECS from the timing controller TC and may generate emission signals in response to the second control signal ECS. The emission driver EDC may provide the emission signals to the emission lines ESL1 to ESLn.

The data driver DDC may receive a third control signal DCS and image data RGB from the timing controller TC. The data driver DDC may convert the image data RGB in a digital form to analog data signals, e.g., data voltages. The data driver DDC may provide the data signals to the data lines DL1 to DLm in response to the third control signal DCS.

The power supply unit PWS may generate the first power voltage VDD, the second power voltage VSS, the third power voltage VREF, the fourth power voltage VINT1, the fifth power voltage VINT2, and the sixth power voltage VCOMP in response to a fourth control signal PCS from the timing controller TC.

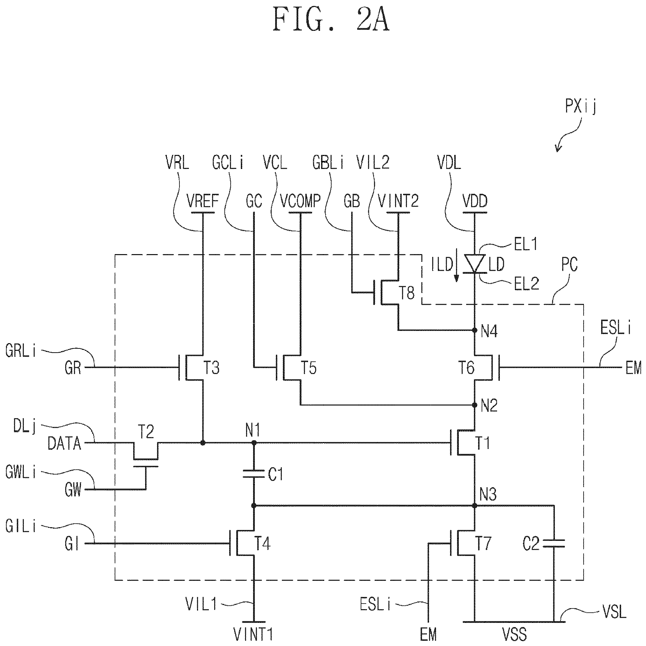

The power supply unit PWS may provide the first power voltage VDD, the second power voltage VSS, the third power voltage VREF, the fourth power voltage VINT1, the fifth power voltage VINT2, and the sixth power voltage VCOMP to the display panel DP. The first power voltage VDD, the second power voltage VSS, the third power voltage VREF, the fourth power voltage VINT1, the fifth power voltage VINT2, and the sixth power voltage VCOMP may be provided to the pixel PXij via power lines (refer to FIG. 2A) connected to the pixel PXij.

The timing controller TC may generate the first control signal SCS, the second control signal ECS, the third control signal DCS, and the fourth control signal PCS based on input image data IRGB, synchronization signals Sync, e.g., a vertical synchronization signal, a horizontal synchronization signal, etc., a data enable signal DE, and a clock signal.

The first control signal SCS may be applied to the scan driver SDC, and the second control signal ECS may be applied to the emission driver EDC. The third control signal DCS may be applied to the data driver DDC, and the fourth control signal PCS may be applied to the power supply unit PWS.

The timing controller TC may rearrange the input image data IRGB to correspond to an arrangement of the pixels in the display panel DP and may generate the image data RGB (or frame data).

The scan driver SDC, the emission driver EDC, the data driver DDC, the power supply unit PWS, and/or the timing controller TC may be formed (e.g., directly formed) in the display panel DP or may be connected (e.g., electrically connected) to the display panel DP after being implemented in a separate driving chip. For example, at least two of the scan driver SDC, the emission driver EDC, the data driver DDC, the power supply unit PWS, and the timing controller TC may be implemented in a single driving chip. As an example, the data driver DDC and the timing controller TC may be provided in the single driving chip.

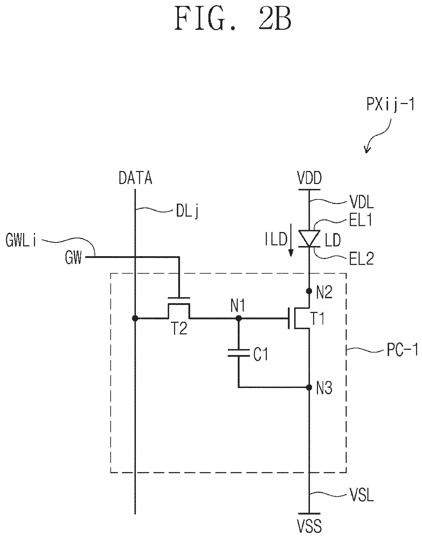

FIGS. 2A and 2B are schematic diagrams of equivalent circuits of pixels PXij and PXij-1.

FIGS. 2A and 2B show the equivalent circuits of the pixels PXij and PXij-1, which are connected to the i-th first scan line GWLi and the j-th data line DLj.

Referring to FIG. 2A, the pixel PXij may include the light emitting element LD and a pixel driving unit PC. The light emitting element LD may be connected (e.g., electrically connected) between a first power line VDL and the pixel driving unit PC. The light emitting element LD may be driven by the pixel driving unit PC and may emit the light.

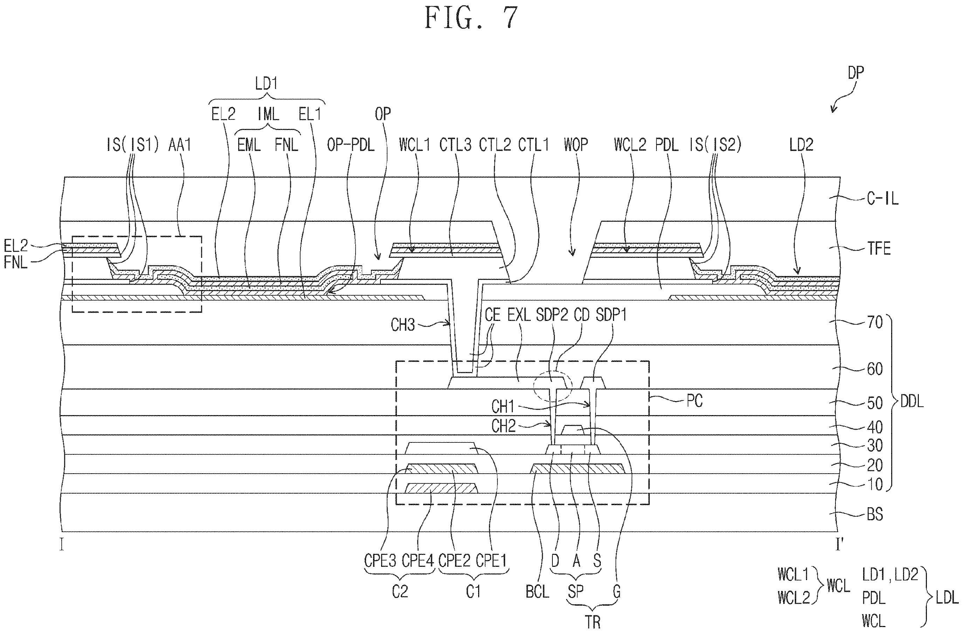

The light emitting element LD may include a first electrode (or an anode) EL1, a second electrode (or a cathode) EL2, and a light emitting layer (refer to FIG. 7) disposed between the first electrode EL1 and the second electrode EL2. The first power voltage VDD may be applied to the first electrode EL1, and the second power voltage VSS may be applied to the second electrode EL2.

The pixel driving unit PC may be connected (e.g., electrically connected) to the i-th first, second, third, fourth, and fifth scan lines GWLi, GCLi, GILi, GBLi, and GRLi, the j-th data line (hereinafter, referred to as a data line) DLj, the i-th emission line (hereinafter, referred to as an emission line) ESLi, and power voltage lines VDL, VSL, VIL1, VIL2, VRL, and VCL. The pixel driving unit PC may include first, second, third, fourth, fifth, sixth, seventh, and eighth transistors T1, T2, T3, T4, T5, T6, T7, and T8, a first capacitor C1, and a second capacitor C2.

Hereinafter, the i-th first, second, third, fourth, and fifth scan lines GWLi, GCLi, GILi, GBLi, and GRLi may be referred to as the write scan line GWLi, the compensation scan line GCLi, the first initialization scan line GILi, the second initialization scan line GBLi, and the reset scan line GRLi.

Hereinafter, all the first, second, third, fourth, fifth, sixth, seventh, and eighth transistors T1, T2, T3, T4, T5, T6, T7, and T8 will be described as the N-type transistor, however, they are not limited thereto or thereby. Some of the first to eighth transistors T1 to T8 may be the N-type transistor, and the other of the first to eighth transistors T1 to T8 may be the P-type transistor, or each of the first to eighth transistors T1 to T8 may be the P-type transistor.

Each of the first to eighth transistors T1 to T8 may include a source, a drain, and a gate. Hereinafter, one of the source and the drain may be referred to as the first electrode, and the other of the source and the drain may be referred to as the second electrode in FIGS. 2A and 2B.

The first transistor T1 may be switched (or turned) on and off by a voltage of a first node N1. The first transistor T1 may be connected (e.g., electrically connected) to the second electrode EL2 of the light emitting element LD via the sixth transistor T6. The first transistor T1 may be connected (e.g., electrically connected) to a second power line VSL via the seventh transistor T7.

The first transistor T1 may include the gate connected to the first node N1, the first electrode connected to a second node N2, and the second electrode connected to a third node N3. The first transistor T1 may be a driving transistor.

The first transistor T1 may control a driving current ILD flowing from the first power line VDL to the second power line VSL via the light emitting element LD in response to the voltage of the first node N1. For example, the first power voltage VDD may be set to have a voltage level higher than the second power voltage VSS.

The second transistor T2 may be connected (e.g., electrically connected) between the first node N1 and the data line DLj and may be switched on and off by a write scan signal GW. The second transistor T2 may include the gate connected to the write scan line GWLi, the first electrode connected to the data line DLj, and the second electrode connected to the first node N1. The data line DLj may receive a data signal DATA.

The second transistor T2 may provide the data signal DATA to the first node N1 in response to the write scan signal GW applied thereto via the write scan line GWLi. The second transistor T2 may be turned on in response to the write scan signal GW, and thus, the second transistor T2 may electrically connect the data line DLj to the first node N1. The data signal DATA provided to the first node N1 may be charged in the first capacitor C1.

The third transistor T3 may be connected (e.g., electrically connected) between the first node N1 and a reference voltage line VRL. The third transistor T3 may include the gate connected to the reset scan line GRLi, the first electrode connected to the reference voltage line VRL, and the second electrode connected to the first node N1.

The reference voltage line VRL may receive the reference voltage VREF, and the reset scan line GRLi may receive a reset scan signal GR. The third transistor T3 may be turned on in response to the reset scan signal GR and may provide the reference voltage VREF to the first node N1.

The fourth transistor T4 may be connected (e.g., electrically connected) between the third node N3 and a first initialization voltage line VIL1. The fourth transistor T4 may include the gate connected to the first initialization scan line GILi, the first electrode connected to the third node N3, and the second electrode connected to the first initialization voltage line VIL1.

The first initialization scan line GILi may receive a first initialization scan signal GI, and the first initialization voltage line VIL1 may receive the first initialization voltage VINT1. The fourth transistor T4 may be turned on in response to the first initialization scan signal GI and may provide the first initialization voltage VINT1 to the third node N3.

The fifth transistor T5 may be connected (e.g., electrically connected) between a compensation voltage line VCL and the second node N2. The fifth transistor T5 may include the gate connected to the compensation scan line GCLi, the first electrode connected to the compensation voltage line VCL, and the second electrode connected to the second node N2.

The compensation scan line GCLi may receive a compensation scan signal GC, and the compensation voltage line VCL may receive the compensation voltage VCOMP. The fifth transistor T5 may be turned on in response to the compensation scan signal GC and may provide the compensation voltage VCOMP to the second node N2, and thus, the threshold voltage of the first transistor T1 may be compensated for during a compensation period.

The sixth transistor T6 may be connected (e.g., electrically connected) between the first transistor T1 and the light emitting element LD. The sixth transistor T6 may include the gate connected to the emission line ESLi, the first electrode connected to a fourth node N4, and the second electrode connected to the second node N2.

The emission line ESLi may receive an emission signal EM. The sixth transistor T6 may be turned on in response to the emission signal EM, and thus, the light emitting element LD may be electrically connected to the first transistor T1.

The seventh transistor T7 may be connected (e.g., electrically connected) between the second power line VSL and the third node N3. The seventh transistor T7 may include the gate connected to the emission line ESLi, the first electrode connected to the third node N3, and the second electrode connected to the second power line VSL.

The second power line VSL may receive the second power voltage VSS. The seventh transistor T7 may be turned on in response to the emission signal EM and may electrically connect the first transistor T1 to the second power line VSL.

The sixth transistor T6 and the seventh transistor T7 may be connected (e.g., electrically connected) to the same emission line ESLi and may be turned on in response to the same emission signal EM, however, this is an example. The sixth transistor T6 and the seventh transistor T7 may be independently turned on in response to different signals distinguished from each other. For example, one of the sixth transistor T6 and the seventh transistor T7 may be omitted from the pixel driving unit PC.

The eighth transistor T8 may be connected (e.g., electrically connected) between a second initialization voltage line VIL2 and the fourth node N4. The eighth transistor T8 may include the gate connected to the second initialization scan line GBLi, the first electrode connected to the second initialization voltage line VIL2, and the second electrode connected to the fourth node N4.

The second initialization scan line GBLi may receive a second initialization scan signal GB, and the second initialization voltage line VIL2 may receive the second initialization voltage VINT2. The eighth transistor T8 may be turned on in response to the second initialization scan signal GB and may provide the second initialization voltage VINT2 to the fourth node N4 connected to the second electrode EL2 of the light emitting element LD. The second electrode EL2 of the light emitting element LD may be initialized by the second initialization voltage VINT2.

The fifth transistor T5 and the eighth transistor T8 may be substantially simultaneously turned on in response to the same scan signal and may receive the same voltage. As an example, the fifth transistor T5 and the eighth transistor T8 may be substantially simultaneously turned on and off in response to the same compensation scan signal GC.

For example, the compensation scan line GCLi and the second initialization scan line GBLi may be substantially provided as a single scan line. Accordingly, the initialization of the cathode of the light emitting element LD and the compensation of the threshold voltage of the first transistor T1 may be performed at the same timing.

The initialization of the second electrode EL2 of the light emitting element LD and the compensation of the threshold voltage of the first transistor T1 may be performed in response to the same power voltage. As an example, the compensation voltage line VCL and the second initialization voltage line VIL2 may be substantially provided as a single power voltage line. For example, the initialization of the second electrode EL2 of the light emitting element LD and the compensation of the threshold voltage of the first transistor T1 may be performed by using a single power voltage, and thus, a design for the drivers may be simplified.

The first capacitor C1 may be connected (e.g., electrically connected) between the first node N1 and the third node N3. The first capacitor C1 may be charged with charges corresponding to a difference in voltage between the first node N1 and the third node N3. The first capacitor C1 may be referred to as a storage capacitor.

The first capacitor C1 may include a first capacitor electrode connected to the first node N1 and a second capacitor electrode connected to the third node N3. The second capacitor electrode may be connected (e.g., electrically connected) between the first transistor T1 and the second power line VSL. The first capacitor electrode may be connected to the gate of the first transistor T1, and the second capacitor electrode may be connected (e.g., electrically connected) to the second electrode of the first transistor T1.

The second capacitor C2 may be connected (e.g., electrically connected) between the third node N3 and the second power line VSL. The second capacitor C2 may include a third capacitor electrode connected to the third node N3 and a fourth capacitor electrode connected to the second power line VSL. The second capacitor C2 may be charged with electric charges corresponding to a difference in voltage between the second power voltage VSS and the third node N3. The second capacitor C2 may be referred to as a hold capacitor.

The second capacitor C2 may have a higher storage capacity as compared with the first capacitor C1. Accordingly, the second capacitor C2 may reduce a variation in voltage of the third node N3 according to a variation in voltage of the first node N1.

The light emitting element LD may be connected (e.g., electrically connected) to the pixel driving unit PC via the fourth node N4. The first electrode EL1 of the light emitting element LD may be connected (e.g., electrically connected) to the first power line VDL, and the second electrode EL2 of the light emitting element LD may be connected to the fourth node N4. The light emitting element LD may be connected (e.g., electrically connected) to the pixel driving unit PC through the second electrode EL2 thereof.

A connection node at which the light emitting element LD is connected to the pixel driving unit PC may be the fourth node N4, and the fourth node N4 may correspond to a connection node between the first electrode of the sixth transistor T6 and the second electrode EL2 of the light emitting element LD. Accordingly, an electric potential of the fourth node N4 may correspond to an electric potential of the second electrode EL2 of the light emitting element LD.

The first power voltage VDD that is a constant voltage may be applied to the first electrode EL1 of the light emitting element LD, and the second electrode EL2 of the light emitting element LD may be electrically connected to the first transistor T1 via the sixth transistor T6. According to the connection structure, an electric potential of the third node N3 corresponding to the source of the first transistor T1, which is the driving transistor, may not be directly affected by characteristics of the light emitting element LD in an implementation where the first to eighth transistors T1 to T8 are the N-type transistor.

Accordingly, even though the characteristics of the light emitting element LD are deteriorated, an influence of the deterioration exerting on the transistors forming the pixel driving unit PC may be reduced. For example, the influence of the deterioration in the characteristics of the light emitting element LD on a gate-source voltage Vgs of the driving transistor may be reduced. For example, since a change in an amount of current is reduced even though the light emitting element is deteriorated, an image retention defect of the display panel according to the increase in usage time may be reduced, and a lifespan of the display panel may be improved.

Referring to FIG. 2B, the pixel PXij-1 may include a pixel driving unit PC-1 including two transistors T1 and T2 and one capacitor C1. The pixel driving unit PC-1 may be connected (e.g., electrically connected) to a light emitting element LD, a write scan line GWLi, a data line DLj, and a second power line VSL. The pixel driving unit PC-1 shown in FIG. 2B may correspond to a circuit configuration obtained by removing the third to eighth transistors T3 to T8 and the second capacitor C2 from the pixel driving unit PC shown in FIG. 2A.

A first transistor T1 may include a gate connected to a first node N1, a first electrode connected to a second node N2, and a second electrode connected to a third node N3. The first transistor T1 may be connected (e.g., electrically connected) to the light emitting element LD via the second node N2 and may be connected (e.g., electrically connected) to the second power line VSL via the third node N3. The first transistor T1 may be a driving transistor.

A second transistor T2 may include a gate receiving a write scan signal GW via the write scan line GWLi, a first electrode connected to the data line DLj, and a second electrode connected to the first node N1. The second transistor T2 may provide a data signal DATA to the first node N1 in response to the write scan signal GW applied thereto via the write scan line GWLi.

The capacitor C1 may include a first capacitor electrode connected to the first node N1 and a second capacitor electrode connected to the third node N3. The capacitor C1 may be charged with the data signal DATA applied to the first node N1.

A first electrode EL1 of the light emitting element LD may be connected (e.g., electrically connected) to a first power line VDL, and a second electrode EL2 of the light emitting element LD may be connected (e.g., electrically connected) to the pixel driving unit PC-1 via the second node N2. The second electrode EL2 may be connected (e.g., electrically connected) to the first transistor T1. The light emitting element LD may emit a light in response to an amount of current flowing through the first transistor T1 of the pixel driving unit PC-1.

FIGS. 2A and 2B show the circuit configurations of the pixel driving units PC and PC-1. The number and the arrangement of the transistors and the number and the arrangement of the capacitors may be designed in various ways.

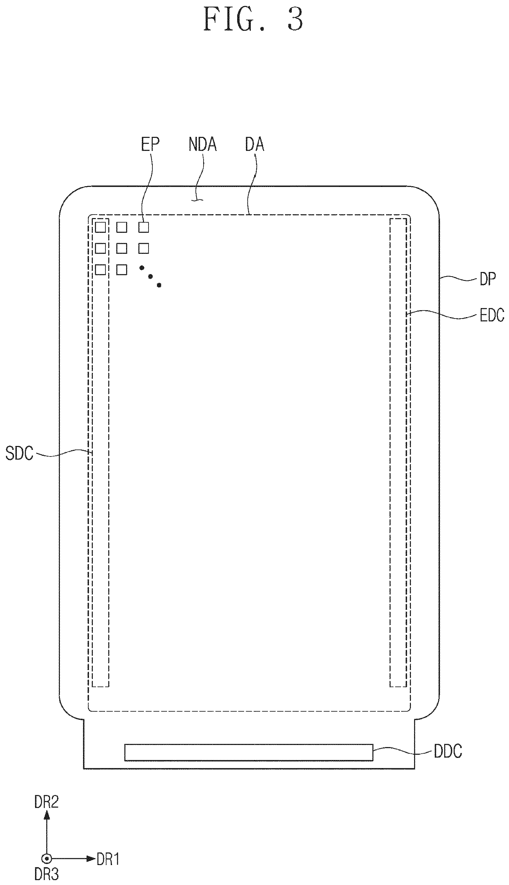

FIG. 3 is a schematic plan view of the display panel DP.

In FIG. 3, some components, e.g., lines, of the display panel DP are omitted for descriptive convenience.

Referring to FIG. 3, the display panel DP may extend longer in a second direction DR2 than in a first direction DR1. The first direction DR1 and the second direction DR2 may intersect with each other. Hereinafter, a third direction DR3 may be defined as a direction that is substantially perpendicular to a plane defined by the first and second directions DR1 and DR2. The expression "when viewed in the plane" or "in plan view" may mean a state of being viewed in the third direction DR3.

The display panel DP may include a display area DA and a non-display area NDA around the display area DA. The display area DA may include light emitting portions EP. The light emitting portions EP may be areas where the pixels emit the light. For example, each of the light emitting portions EP may correspond to a light emitting opening OP-PDL described below. The non-display area NDA may be defined adjacent to the display area DA. The non-display area NDA may surround the display area DA.

The scan driver SDC, the emission driver EDC, and the data driver DDC may be mounted on the display panel DP. As an example, the scan driver SDC and the emission driver EDC may be disposed in the display area DA, and the data driver DDC may be disposed in the non-display area NDA. In plan view, the data driver DDC may be disposed in the non-display area NDA adjacent to a lower side of the display panel DP.

The scan driver SDC and the emission driver EDC may overlap some of the light emitting portions EP arranged in the display area DA in plan view. As an example, the scan driver SDC and the emission driver EDC may be disposed to overlap the light emitting portions adjacent to both sides of the display area DA, which are opposite to each other in the first direction DR1.

The pixel driving units PC may not be disposed under the light emitting portions EP adjacent to the both sides of the display area DA. Accordingly, circuits forming the scan driver SDC and the emission driver EDC may be disposed under the light emitting portions EP adjacent to the both sides of the display area DA. This configuration will be described below.

In a case where the scan driver SDC and the emission driver EDC are disposed in the non-display area NDA, a size of the non-display area NDA may increase. However, since the scan driver SDC and the emission driver EDC are disposed not in the non-display area NDA but in the display area DA, the size of the non-display area NDA may decrease.

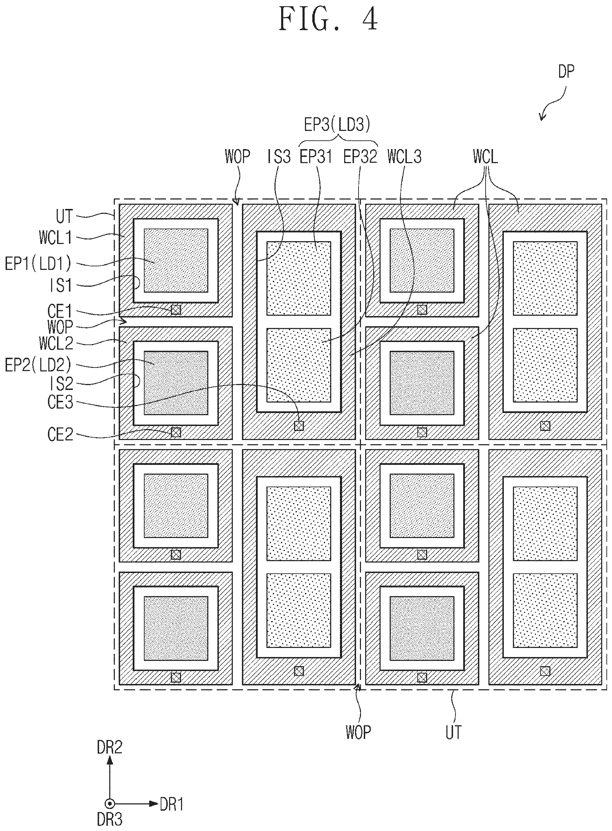

FIG. 4 is an enlarged schematic plan view of some areas of the display area of the display panel DP.

Referring to FIG. 4, the display panel DP may include light emitting units UT, a barrier wall conductive layer WCL, and light emitting connection portions CE1, CE2, and CE3. FIG. 4 shows light emitting units UT arranged in two rows by two columns. The row may correspond to the first direction DR1, and the column may correspond to the second direction DR2.

The light emitting units UT may be arranged in the first direction DR1 and the second direction DR2. Each of the light emitting units UT may include a first light emitting portion EP1, a second light emitting portion EP2, and a third light emitting portion EP3.

The first light emitting portions EP1, the second light emitting portions EP2, and the third light emitting portions EP3 may emit lights having different colors. As an example, the first light emitting portions EP1 may emit a red light, the second light emitting portions EP2 may emit a green light, and the third light emitting portions EP3 may emit a blue light.

In each of the light emitting units UT, the first light emitting portion EP1 and the second light emitting portion EP2 may be arranged in the second direction DR2. In each of the light emitting units UT, the third light emitting portion EP3 and the first and second light emitting portions EP1 and EP2 may be arranged in the first direction DR1.

Each of the third light emitting portions EP3 may include a third-first sub-light emitting portion EP31 and a third-second sub-light emitting portion EP32 spaced apart from the third-first sub-light emitting portion EP31 in the second direction DR2, however, this is an example. Like the first light emitting portion EP1 and the second light emitting portion EP2, the third light emitting portion EP3 may be formed as a single pattern in an integral shape.

Each of the first, second, and third light emitting portions EP1, EP2, and EP3 may be a portion corresponding to the light emitting opening OP-PDL (refer to FIG. 7) described below. For example, each of the light emitting portions EP1, EP2, and EP3 may be defined as areas on the plane through which the light is displayed.

In plan view, each of the first, second, and third light emitting portions EP1, EP2, and EP3 may be defined as areas overlapping the light emitting opening OP-PDL (refer to FIG. 7). Each of the first, second, and third light emitting portions EP1, EP2, and EP3 may be defined as an area where the first electrode EL1, the light emitting layer EML, and the second electrode EL2 shown in FIG. 7 overlap each other.

The first light emitting portions EP1 may be configured by first light emitting elements LD1, the second light emitting portions EP2 may be configured by second light emitting elements LD2, and the third light emitting portions EP3 may be configured by third light emitting elements LD3. Accordingly, an arrangement of the first, second, and third light emitting portions EP1, EP2, and EP3 may correspond to an arrangement of the first, second, and third light emitting elements LD1, LD2, and LD3 in plan view. Each of the first, second, and third light emitting elements LD1, LD2, and LD3 may correspond to the light emitting element LD shown in FIG. 2A.

For example, each of the light emitting units UT includes the first light emitting element LD1, the second light emitting element LD2, and the third light emitting element LD3. The first, second, and third light emitting elements LD1, LD2, and LD3 may have substantially the same structure.

In plan view, the first, second, and third light emitting portions EP1, EP2, and EP3 may be disposed in areas partitioned by the barrier wall conductive layer WCL. The barrier wall conductive layer WCL may be formed to surround the first, second, and third light emitting portions EP1, EP2, and EP3.

The barrier wall conductive layer WCL may include a conductive material. As an example, the barrier wall conductive layer WCL may include metal layers stacked in multiple layers. The structure of the barrier wall conductive layer WCL in a cross-section will be described with reference to FIG. 7.

A barrier wall opening WOP may be defined through the barrier wall conductive layer WCL. In plan view, the barrier wall opening WOP may be defined between the first, second, and third light emitting portions EP1, EP2, and EP3. In plan view, the barrier wall opening WOP may extend in the first direction DR1 and the second direction DR2.

The barrier wall opening WOP may be defined between the first and second light emitting portions EP1 and EP2 and may extend in the first direction DR1. The barrier wall opening WOP may be defined between the first and third light emitting portions EP1 and EP3 and between the second and third light emitting portions EP2 and EP3 and may extend in the second direction DR2. The barrier wall opening WOP extending in the first direction DR1 may be integral with the barrier wall opening WOP extending in the second direction DR2.

The barrier wall conductive layer WCL may be divided into a plurality of portions by the barrier wall opening WOP. The barrier wall conductive layer WCL may include first barrier wall conductive layers WCL1, second barrier wall conductive layers WCL2, and third barrier wall conductive layers WCL3, which are divided by the barrier wall opening WOP.

In plan view, the first barrier wall conductive layers WCL1 may be disposed respectively adjacent to the first light emitting portions EP1 and may respectively surround the first light emitting portions EP1. As an example, the first light emitting portions EP1 may have a quadrangular shape, and the first barrier wall conductive layers WCL1 may have a quadrangular closed-loop shape and may respectively surround of the first light emitting portions EP1. However, the shape of the first light emitting portions EP1 and the shape of the first barrier wall conductive layers WCL1 is not limited thereto or thereby.

The first light emitting portions EP1 may be spaced apart from first inner side surfaces IS1 of the first barrier wall conductive layers WCL1, respectively. Areas where the first light emitting portions EP1 are disposed may be defined by the first inner side surfaces IS1 of the first barrier wall conductive layers WCL1.

In plan view, the second barrier wall conductive layers WCL2 may be respectively disposed adjacent to the second light emitting portions EP2 and may respectively surround the second light emitting portions EP2. As an example, the second light emitting portions EP2 may have a quadrangular shape, and the second barrier wall conductive layers WCL2 may have a quadrangular closed-loop shape and may surround the second light emitting portions EP2. However, the shape of the second light emitting portions EP2 and the shape of the second barrier wall conductive layers WCL2 is not limited thereto or thereby.

The second light emitting portions EP2 may be spaced apart from second inner side surfaces IS2 of the second barrier wall conductive layers WCL2, respectively. Areas where the second light emitting portions EP2 are disposed may be defined by the second inner side surfaces IS2 of the second barrier wall conductive layers WCL2.

In plan view, the third barrier wall conductive layers WCL3 may be respectively disposed adjacent to the third light emitting portions EP3 and may respectively surround the third light emitting portions EP3. As an example, the third light emitting portions EP3 may have a quadrangular shape, and the third barrier wall conductive layers WCL3 may have a quadrangular closed-loop shape and may respectively surround the third light emitting portions EP3. However, the shape of the third light emitting portions EP3 and the shape of the third barrier wall conductive layers WCL3 is not limited thereto or thereby.

The third light emitting portions EP3 may be spaced apart from third inner side surfaces IS3 of the third barrier wall conductive layers WCL3, respectively. Areas where the third light emitting portions EP3 are disposed may be defined by the third inner side surfaces IS3 of the third barrier wall conductive layers WCL3.

The first, second, and third light emitting elements LD1, LD2, and LD3 forming the first, second, and third light emitting portions EP1, EP2, and EP3 may be electrically connected to the first, second, and third barrier wall conductive layers WCL1, WCL2, and WCL3. This structure will be described below.

The first, second, and third barrier wall conductive layers WCL1, WCL2, and WCL3 may be electrically insulated from each other by the barrier wall opening WOP. Since the first, second, and third barrier wall conductive layers WCL1, WCL2, and WCL3 are electrically insulated from each other, the first, second, and third light emitting elements LD1, LD2, and LD3 may also be electrically insulated from each other by the barrier wall opening WOP.

The light emitting connection portions CE1, CE2, and CE3 may be disposed to overlap the barrier wall conductive layer WCL. The light emitting connection portions CE1, CE2, and CE3 may be defined as portions of the barrier wall conductive layer WCL, which respectively connect the first, second, and third light emitting elements LD1, LD2, and LD3 to the transistors. This structure will be described with reference to FIG. 7.

The light emitting connection portions CE1, CE2, and CE3 may include first light emitting connection portions CE1, second light emitting connection portions CE2, and third light emitting connection portions CE3. The first light emitting connection portions CE1 may be disposed to overlap the first barrier wall conductive layers WCL1, respectively. The second light emitting connection portions CE2 may be disposed to overlap the second barrier wall conductive layers WCL2, respectively. The third light emitting connection portions CE3 may be disposed to overlap the third barrier wall conductive layers WCL3, respectively.

In each of the light emitting units UT, the first light emitting connection portion CE1 may be defined as a portion of the first barrier wall conductive layer WCL1. In each of the light emitting units UT, the second light emitting connection portion CE2 may be defined as a portion of the second barrier wall conductive layer WCL2. In each of the light emitting units UT, the third light emitting connection portion CE3 may be defined as a portion of the third barrier wall conductive layer WCL3.

In plan view, the first, second, and third light emitting connection portions CE1, CE2, and CE3 may be disposed adjacent to lower sides of the first, second, and third barrier wall conductive layers WCL1, WCL2, and WCL3, respectively, however, this is an example. The first, second, and third light emitting connection portions CE1, CE2, and CE3 may be disposed to overlap various portions of the first, second, and third barrier wall conductive layers WCL1, WCL2, and WCL3, respectively.

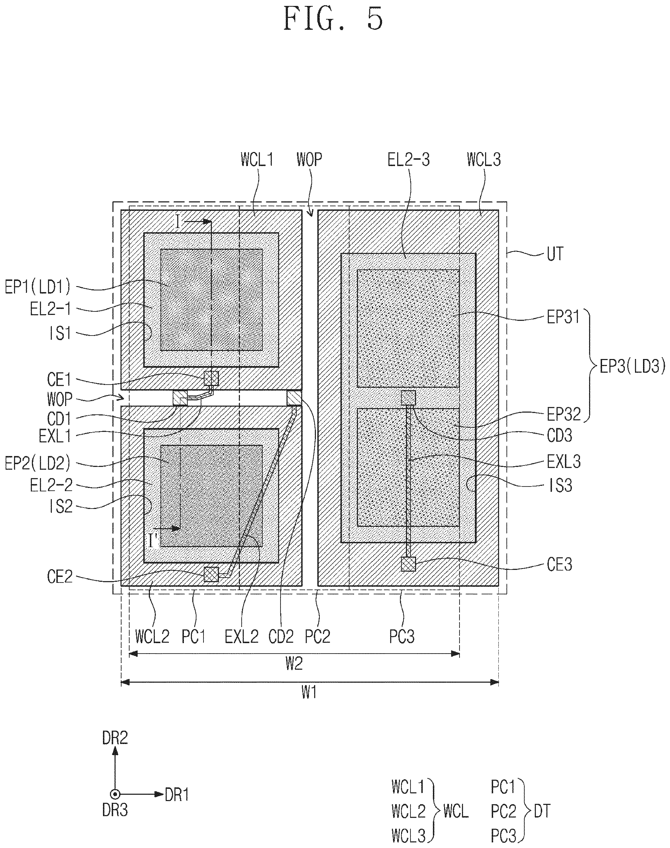

FIG. 5 is a schematic plan view of a light emitting unit shown in FIG. 4 and driving connection portions of the pixel driving units connected to the light emitting unit.

Referring to FIG. 5, the first light emitting element LD1 may include a second-first electrode EL2-1, the second light emitting element LD2 may include a second-second electrode EL2-2, and the third light emitting element LD3 may include a second-third electrode EL2-3. Each of the second-first electrode EL2-1, the second-second electrode EL2-2, and the second-third electrode EL2-3 may correspond to the second electrode EL2 (or cathode) shown in FIG. 2A.

In plan view, the second-first electrode EL2-1 may have a size greater than a size of the first light emitting portion EP1 and may extend toward the first barrier wall conductive layer WCL1. In plan view, the first barrier wall conductive layer WCL1 may surround the second-first electrode EL2-1. The second-first electrode EL2-1 may be in contact with the first inner side surface IS1 of the first barrier wall conductive layer WCL1.

Since the second-first electrode EL2-1 is in contact with the first barrier wall conductive layer WCL1, the second-first electrode EL2-1 may be electrically connected to the first barrier wall conductive layer WCL1. Accordingly, the first light emitting element LD1 may be electrically connected to the first barrier wall conductive layer WCL1 by the second-first electrode EL2-1.

In plan view, the second-second electrode EL2-2 may have a size greater than that of the second light emitting portion EP2 and may extend toward the second barrier wall conductive layer WCL2. In plan view, the second barrier wall conductive layer WCL2 may surround the second-second electrode EL2-2. The second-second electrode EL2-2 may be in contact with the second inner side surface IS2 of the second barrier wall conductive layer WCL2.

Since the second-second electrode EL2-2 is in contact with the second barrier wall conductive layer WCL2, the second-second electrode EL2-2 may be electrically connected to the second barrier wall conductive layer WCL2. Accordingly, the second light emitting element LD2 may be electrically connected to the second barrier wall conductive layer WCL2 by the second-second electrode EL2-2.

In plan view, the second-third electrode EL2-3 may have a size greater than that of the third light emitting portion EP3 and may extend toward the third barrier wall conductive layer WCL3. In plan view, the third barrier wall conductive layer WCL3 may surround the second-third electrode EL2-3. The second-third electrode EL2-3 may be in contact with the third inner side surface IS3 of the third barrier wall conductive layer WCL3.

Since the second-third electrode EL2-3 is in contact with the third barrier wall conductive layer WCL3, the second-third electrode EL2-3 may be electrically connected to the third barrier wall conductive layer WCL3. Accordingly, the third light emitting element LD3 may be electrically connected to the third barrier wall conductive layer WCL3 by the second-third electrode EL2-3.

The display panel DP may include pixel driving units PC1, PC2, and PC3. Each of the pixel driving units PC1, PC2, and PC3 may have substantially the same structure as that of the pixel driving unit PC shown in FIG. 2A. The pixel driving units PC1, PC2, and PC3 may be placed below the first, second, and third light emitting portions EP1, EP2, and EP3.

As an example, the pixel driving units PC1, PC2, and PC3 are indicated by a dotted line in FIG. 5. Each of the pixel driving units PC1, PC2, and PC3 may correspond to the pixel driving unit PC shown in FIG. 2A. The transistors T1 to T8 and the capacitors C1 and C2 shown in FIG. 2A may be disposed in each of the pixel driving units PC1, PC2, and PC3 indicated by the dotted line.

The pixel driving units PC1, PC2, and PC3 may include a first pixel driving unit PC1, a second pixel driving unit PC2, and a third pixel driving unit PC3. The first pixel driving unit PC1 may be connected (e.g., electrically connected) to the first light emitting element LD1, the second pixel driving unit PC2 may be connected (e.g., electrically connected) to the second light emitting element LD2, and the third pixel driving unit PC3 may be connected (e.g., electrically connected) to the third light emitting element LD3.

The display panel DP may include driving connection portions CD1, CD2, and CD3 and extension lines EXL1, EXL2, and EXL3. The extension lines EXL1, EXL2, and EXL3 may extend from the driving connection portions CD1, CD2, and CD3, respectively.

The driving connection portions CD1, CD2, and CD3 may include a first driving connection portion CD1, a second driving connection portion CD2, and a third driving connection portion CD3. The first driving connection portion CD1 may be connected (e.g., electrically connected) to the first pixel driving unit PC1. The second driving connection portion CD2 may be connected (e.g., electrically connected) to the second pixel driving unit PC2. The third driving connection portion CD3 may be connected (e.g., electrically connected) to the third pixel driving unit PC3.

Each of the first, second, and third driving connection portions CD1, CD2, and CD3 may be formed by the drain of the sixth transistor T6 shown in FIG. 2A. For example, the first, second, and third driving connection portions CD1, CD2, and CD3 may be respectively connected to the sixth transistors T6 of the first, second, and third pixel driving units PC1, PC2, and PC3. Each of the first, second, and third driving connection portions CD1, CD2, and CD3 may substantially correspond to the fourth node N4 shown in FIG. 2A.

The first, second, and third driving connection portions CD1, CD2, and CD3 may be arranged in the first direction DR1. The first, second, and third driving connection portions CD1, CD2, and CD3 may be disposed at a center portion of the light emitting unit UT in the second direction DR2 and may be arranged in the first direction DR1. As an example, the first and second driving connection portions CD1 and CD2 may be disposed between the first and second barrier wall conductive layers WCL1 and WCL2. The third driving connection portion CD3 may be disposed between the third-first sub-light emitting portion EP31 and the third-second sub-light emitting portion EP32.

The extension lines EXL1, EXL2, and EXL3 may include a first extension line EXL1, a second extension line EXL2, and a third extension line EXL3. The first extension line EXL1 may extend from the first driving connection portion CD1 and may be connected (e.g., electrically connected) to the first light emitting connection portion CE1. The second extension line EXL2 may extend from the second driving connection portion CD2 and may be connected (e.g., electrically connected) to the second light emitting connection portion CE2. The third extension line EXL3 may extend from the third driving connection portion CD3 and may be connected (e.g., electrically connected) to the third light emitting connection portion CE3.

The first pixel driving unit PC1 may be electrically connected to the first light emitting element LD1 via the first driving connection portion CD1, the first extension line EXL1, and the first light emitting connection portion CE1. As an example, the first pixel driving unit PC1 may be connected (e.g., electrically connected) to the first driving connection portion CD1, the first extension line EXL1 extending from the first driving connection portion CD1 may be connected (e.g., electrically connected) to the first light emitting connection portion CE1, the first light emitting connection portion CE1 may be connected (e.g., electrically connected) to the first barrier wall conductive layer WCL1, and the first barrier wall conductive layer WCL1 may be connected (e.g., electrically connected) to the second-first electrode EL2-1. Accordingly, the first pixel driving unit PC1 may be electrically connected to the second-first electrode EL2-1 of the first light emitting element LD1.

The second pixel driving unit PC2 may be electrically connected to the second light emitting element LD2 via the second driving connection portion CD2, the second extension line EXL2, and the second light emitting connection portion CE2. As an example, the second pixel driving unit PC2 may be connected (e.g., electrically connected) to the second driving connection portion CD2, the second extension line EXL2 extending from the second driving connection portion CD2 may be connected (e.g., electrically connected) to the second light emitting connection portion CE2, the second light emitting connection portion CE2 may be connected (e.g., electrically connected) to the second barrier wall conductive layer WCL2, and the second barrier wall conductive layer WCL2 may be connected (e.g., electrically connected) to the second-second electrode EL2-2. Accordingly, the second pixel driving unit PC2 may be electrically connected to the second-second electrode EL2-2 of the second light emitting element LD2.

The third pixel driving unit PC3 may be electrically connected to the third light emitting element LD3 via the third driving connection portion CD3. As an example, the third pixel driving unit PC3 may be connected (e.g., electrically connected) to the third driving connection portion CD3, the third extension line EXL3 extending from the third driving connection portion CD3 may be connected (e.g., electrically connected) to the third light emitting connection portion CE3, the third light emitting connection portion CE3 may be connected (e.g., electrically connected) to the third barrier wall conductive layer WCL3, and the third barrier wall conductive layer WCL3 may be connected (e.g., electrically connected) to the second-third electrode EL2-3. Accordingly, the third pixel driving unit PC3 may be electrically connected to the second-third electrode EL2-3 of the third light emitting element LD3.

The light emitting unit UT may have a first width W1 in the first direction DR1. The first, second, and third pixel driving units PC1, PC2, and PC3 connected to the light emitting unit UT may be defined as a driving unit DT. The driving unit DT may have a second width W2 smaller than the first width W1 in the first direction DR1.

The driving unit DT and the light emitting unit UT may be provided in plural to the display panel DP. For example, since the driving unit DT has the width smaller than that of the light emitting unit UT, an area in which the driving units DT are disposed may be smaller than an area in which the light emitting units UT are disposed.

The scan driver SDC and the emission driver EDC shown in FIG. 3 may be disposed on the same layer as the driving units DT. Since the driving unit DT has the width smaller than that of the light emitting unit UT, the driving units DT may not be disposed at both sides of the display area DA. Accordingly, the area to place the driving units DT in the display area DA is reduced, and thus as shown in FIG. 3, the scan driver SDC and the emission driver EDC may be disposed at the both sides of the display area DA where the driving units DT are not disposed.

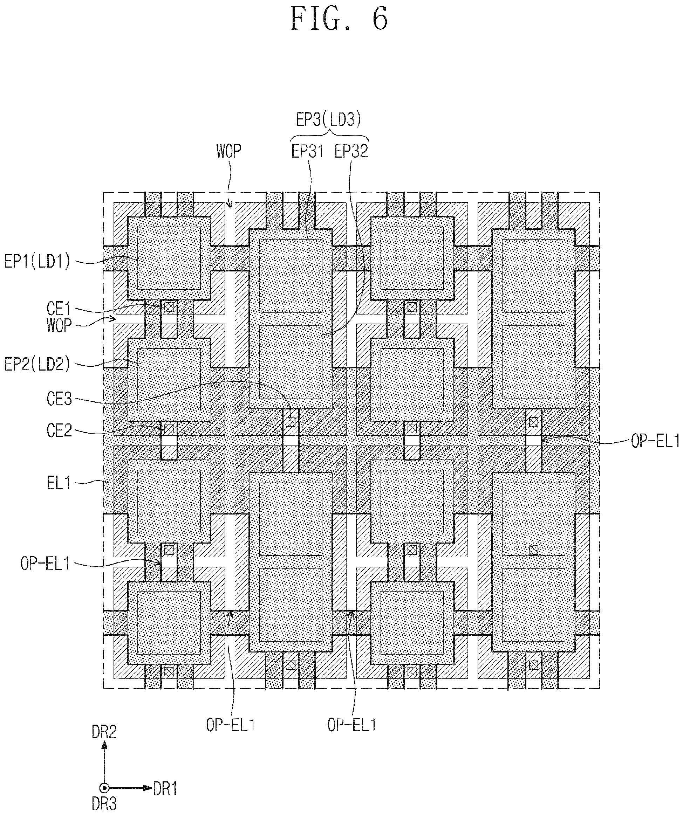

FIG. 6 is a schematic plan view of the first electrode EL1 of the light emitting element shown in FIG. 4.

Referring to FIG. 6, the first electrode EL1 may correspond to the first electrode EL1 (or the anode) shown in FIG. 2A. The first electrode EL1 may be the anode of the first, second, and third light emitting elements LD1, LD2, and LD3. The first electrode EL1 may be commonly provided over the first, second, and third light emitting elements LD1, LD2, and LD3.

In plan view, the first electrode EL1 may overlap the first, second, and third light emitting portions EP1, EP2, and EP3. In plan view, the first electrode EL1 may not overlap the first, second, and third light emitting connection portions CE1, CE2, and CE3.

Certain portions of the first electrode EL1, which overlap the first, second, and third light emitting connection portions CE1, CE2, and CE3, may be removed, and openings OP-EL1 may be defined to overlap the first, second, and third light emitting connection portions CE1, CE2, and CE3. The first electrode EL1 may be partially opened to expose portions of the barrier wall conductive layer WCL. For example, the openings OP-EL1 may be defined through the first electrode EL1 overlapping the portions of the barrier wall conductive layer WCL.

The first electrode EL1 may be defined as a plurality of first electrodes EL1 distinguished from each other and respectively overlapping the first, second, and third light emitting portions EP1, EP2, and EP3. The first electrodes EL1 of the first, second, and third light emitting elements LD1, LD2, and LD3 may be connected (e.g., electrically connected) to each other and may be integral with each other.

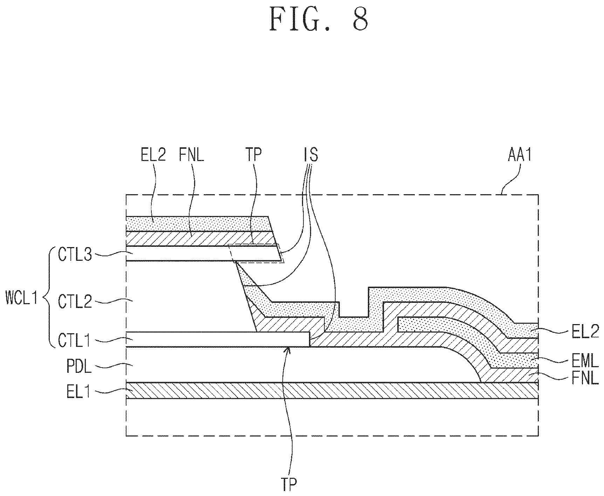

FIG. 7 is a schematic cross-sectional view taken along a line I-I' shown in FIG. 5. FIG. 8 is an enlarged schematic plan view of a first area AA1 shown in FIG. 7.

Referring to FIG. 7, the display panel DP may include a base layer BS, a driving element layer DDL, a light emitting element layer LDL, a thin film encapsulation layer TFE, and a cover insulating layer C-IL.

The base layer BS may provide a base surface on which the pixel driving unit PC is disposed. The base layer BS may be a rigid substrate or a flexible substrate that is bendable, foldable, or rollable. The base layer BS may be a glass substrate, a metal substrate, or a polymer substrate.

The driving element layer DDL may include first, second, third, fourth, fifth, sixth, and seventh insulating layers 10, 20, 30, 40, 50, 60, and 70 sequentially stacked on the base layer BS and the pixel driving unit PC. The pixel driving unit PC may correspond to the pixel driving unit PC shown in FIG. 2A. For example, the pixel driving unit PC may correspond to each of the first, second, and third pixel driving units PC1, PC2, and PC3 shown in FIG. 5. As FIG. 7 shows the cross-section taken along line I-I' of FIG. 5, the pixel driving unit PC of FIG. 7 may be the first pixel driving unit PC1 shown in FIG. 5.

A transistor TR and the first and second capacitors C1 and C2 of the pixel driving unit PC may be disposed on the base layer BS. The transistor TR may be the sixth transistor T6 shown in FIG. 2A. The transistor TR may be defined as a connection transistor connected to the fourth node N4 shown in FIG. 2A. For example, the transistor TR may be the sixth transistor T6 of the first pixel driving unit PC1.

For example, other transistors of the pixel driving unit PC may be disposed on the base layer BS and may have substantially the same structure as that of the transistor TR.

The first insulating layer 10 may be disposed on the base layer BS. A lower conductive layer BCL may be disposed on the first insulating layer 10. The second insulating layer 20 may be disposed on the lower conductive layer BCL. The second insulating layer 20 may be disposed on the first insulating layer 10 to cover the lower conductive layer BCL.

The lower conductive layer BCL may prevent an electric potential caused by a polarization phenomenon of the base layer BS from exerting influence on the transistor TR. The lower conductive layer BCL may block a light incident into the transistor TR from a lower side of the base layer BS. For example, the lower conductive layer BCL may include a reflective metal material.

For example, the lower conductive layer BCL may be connected (e.g., electrically connected) to a source electrode pattern layer SDP1, however, implementations are not limited thereto or thereby. The lower conductive layer BCL may be connected (e.g., electrically connected) to a gate electrode G of the transistor TR. The lower conductive layer BCL may be provided in an isolated form isolated from other conductive pattern layers. The lower conductive layer BCL may receive a constant voltage.

The transistor TR may be disposed on the second insulating layer 20. The transistor TR may include a semiconductor pattern layer SP and the gate electrode G. The semiconductor pattern layer SP may be disposed on the second insulating layer 20.

The semiconductor pattern layer SP may include an oxide semiconductor. As an example, the oxide semiconductor may include a transparent conductive oxide (TCO), such as indium tin oxide (ITO), indium zinc oxide (IZO), indium gallium zinc oxide (IGZO), zinc oxide (ZnO), indium oxide (InzOs), or the like, however, the material for the semiconductor pattern layer SP is not limited thereto or thereby. As an example, the semiconductor pattern layer SP may include amorphous silicon, low temperature polycrystalline silicon, or polycrystalline silicon.

The semiconductor pattern layer SP may include a source area S, a drain area D, and a channel area A, which are distinguished from each other depending on a degree of conductivity. The channel area A may be a portion of the semiconductor pattern layer SP overlapping the gate electrode G in plan view. The source area S and the drain area D may be portions of the semiconductor pattern layer SP, which are spaced apart from each other with the channel area A interposed therebetween.

The source area S and the drain area D may have a relatively high conductivity as compared with the channel area A. The source area S may correspond to a source electrode of the transistor TR, and the drain area D may correspond to a drain electrode of the transistor TR.

The third insulating layer 30 may be disposed on the semiconductor pattern layer SP. The third insulating layer 30 may be disposed on the second insulating layer 20 to cover the semiconductor pattern layer SP.

The gate electrode G of the transistor TR may be disposed on the third insulating layer 30. The gate electrode G may be disposed on the semiconductor pattern layer SP and may overlap the channel area A. The gate electrode G of the transistor TR may function as the gate of the transistor TR.

The fourth insulating layer 40 may be disposed on the gate electrode G. The fourth insulating layer 40 may be disposed on the third insulating layer 30 to cover the gate electrode G. The fifth insulating layer 50 may be disposed on the fourth insulating layer 40, and the source electrode pattern layer SDP1 and a drain electrode pattern layer SDP2 may be disposed on the fifth insulating layer 50. The first to fifth insulating layers 10 to 50 may be an inorganic layer or an organic layer.

The source electrode pattern layer SDP1 may be connected (e.g., electrically connected) to the source area S of the transistor TR via a first contact hole CH1 defined through the third, fourth, and fifth insulating layers 30, 40, and 50. The source electrode pattern layer SDP1 and the source area S of the semiconductor pattern layer SP may function as the source of the transistor TR.

The drain electrode pattern layer SDP2 may be connected to the drain area D of the transistor TR via a second contact hole CH2 defined through the third, fourth, and fifth insulating layers 30, 40, and 50. The drain electrode pattern layer SDP2 and the drain area D of the semiconductor pattern layer SP may function as the drain of the transistor TR.

The sixth insulating layer 60 may be disposed on the source electrode pattern layer SDP2 and the drain electrode pattern layer SDP2. The sixth insulating layer 60 may be disposed on the fifth insulating layer 50 to cover the source electrode pattern layer SDP1 and the drain electrode pattern layer SDP2. The seventh insulating layer 70 may be disposed on the sixth insulating layer 60. Each of the sixth and seventh insulating layers 60 and 70 may be an organic layer.

The first capacitor C1 may include a first capacitor electrode CPE1 and a second capacitor electrode CPE2 disposed under the first capacitor electrode CPE1. In plan view, the first capacitor electrode CPE1 may overlap the second capacitor electrode CPE2. The first capacitor electrode CPE1 may be connected (e.g., electrically connected) to the first node N1, and the second capacitor electrode CPE2 may be connected (e.g., electrically connected) to the third node N3.

The first capacitor electrode CPE1 and the semiconductor pattern layer SP may be disposed on the same layer (e.g., the second insulating layer 20). The second capacitor electrode CPE2 and the lower conductive layer BCL may be disposed on the same layer (e.g., the first insulating layer 10). The first capacitor electrode CPE1 and the semiconductor pattern layer SP may be substantially simultaneously formed by patterning the same material. The second capacitor electrode CPE2 and the lower conductive layer BCL may be substantially simultaneously formed by patterning the same material.

The second capacitor C2 may include a third capacitor electrode CPE3 and a fourth capacitor electrode CPE4 disposed under the third capacitor electrode CPE3. In plan view, the third capacitor electrode CPE3 may overlap the fourth capacitor electrode CPE4. The third capacitor electrode CPE3 may be connected (e.g., electrically connected) to the third node N3, and the fourth capacitor electrode CPE4 may be connected (e.g., electrically connected) to the second power line VSL. The third capacitor electrode CPE3 and the lower conductive layer BCL may be substantially simultaneously formed by patterning the same material.

The third capacitor electrode CPE3 may be the second capacitor electrode CPE2. For example, the first capacitor C1 and the second capacitor C2 may share one capacitor electrode.

The fourth capacitor electrode CPE4 may be disposed on the base layer BS. The first insulating layer 10 may be disposed on the base layer BS to cover the fourth capacitor electrode CPE4.

A portion of the drain electrode pattern layer SDP2, which overlaps the second contact hole CH2, may be defined as a driving connection portion CD. The first, second, and third driving connection portions CD1, CD2, and CD3 shown in FIG. 5 may correspond to the driving connection portion CD. As FIG. 7 shows the cross-section taken along line I-I' of FIG. 5, the driving connection portion CD of FIG. 7 may be the first driving connection portion CD1 shown in FIG. 5.

The light emitting element layer LDL may be disposed on the seventh insulating layer 70. The light emitting element layer LDL may include the first and second light emitting elements LD1 and LD2, a pixel definition layer PDL, and the barrier wall conductive layer WCL. Each of the first and second light emitting elements LD1 and LD2 may correspond to the light emitting element LD shown in FIG. 2A. The first and second light emitting elements LD1 and LD2 may correspond to the first and second light emitting elements LD1 and LD2 shown in FIG. 5.

For example, the third light emitting element LD3 shown in FIG. 5 may have substantially the same structure as the first and second light emitting elements LD1 and LD2.

Each of the first and second light emitting elements LD1 and LD2 may include the first electrode EL1, an intermediate layer IML, and the second electrode EL2. The first electrodes EL1 of the first and second light emitting elements LD1 and LD2 may be the first electrode EL1 (or the anode) shown in FIGS. 2A and 6. For example, the first electrodes EL1 may be connected (e.g., electrically connected) to each other and may be integral with each other as shown in FIG. 6.

The first electrodes EL1 may be disposed on the seventh insulating layer 70, and the pixel definition layer PDL may be disposed on the first electrodes EL1 and the seventh insulating layer 70. The pixel definition layer PDL may be an inorganic layer.

The light emitting openings OP-PDL, in which the first light emitting element LD1 and the second light emitting element LD2 are disposed, may be defined through the pixel definition layer PDL. The certain portions of the first electrodes EL1 disposed under the pixel definition layer PDL may be exposed through the light emitting openings OP-PDL. The exposed portions of the first electrodes EL1 may form the first electrode EL1 of the first light emitting element LD1 and the first electrode EL1 of the second light emitting element LD2.

For example, the light emitting opening OP-PDL in which the third light emitting element LD3 is disposed may be further defined through the pixel definition layer PDL, and a certain portion of the first electrode EL1 of the third light emitting element LD3 may be exposed through the light emitting opening OP-PDL.

Components of the first and second light emitting elements LD1 and LD2 may be disposed in the light emitting openings OP-PDL to overlap each other, the lights emitted from the first and second light emitting elements LD1 and LD2 may be displayed through the light emitting openings OP-PDL. The first and second light emitting portions EP1 and EP2 (refer to FIG. 4) may have a shape substantially corresponding to areas of the light emitting openings OP-PDL in the plane. For example, the third light emitting portion EP3 may have a shape corresponding to an area of a corresponding light emitting opening OP-PDL in the plane.

Since the first light emitting element LD1 and the second light emitting element LD2 have substantially the same structure as each other, hereinafter, descriptions will be focused on the first light emitting element LD1. For example, the third light emitting element LD3 may have substantially the same structure as the first light emitting element LD1.

The second electrode EL2 may be disposed on the first electrode EL1, and the intermediate layer IML may be disposed between the first electrode EL1 and the second electrode EL2. The second electrode EL2 of the first light emitting element LD1 may be the second-first electrode EL2-1 shown in FIG. 5, and the second electrode EL2 of the second light emitting element LD2 may be the second-second electrode EL2-2 shown in FIG. 5.

The intermediate layer IML may include the light emitting layer EML and a functional layer FNL. The first light emitting element LD1 may include the intermediate layer IML with various structures, but implementations are not limited thereto. As an example, the functional layer FNL may be provided in multiple layers and may include two or more layers spaced apart from each other with the light emitting layer EML interposed therebetween.

The light emitting layer EML may include an organic light emitting material. For example, the light emitting layer EML may include an inorganic light emitting material or may include a mixed layer of an organic light emitting material and an inorganic light emitting material. The light emitting layer EML may emit a light having one of blue, red, and green colors.

The functional layer FNL may be disposed between the first electrode EL1 and the second electrode EL2. The functional layer FNL may be disposed between the first electrode EL1 and the light emitting layer EML and between the second electrode EL2 and the light emitting layer EML. According to this structure, the light emitting layer EML may be disposed in the functional layer FNL to overlap the light emitting opening OP-PDL. For example, the functional layer FNL may be disposed (e.g., directly disposed) on an upper surface of the the light emitting layer EML, and may be disposed (e.g., directly disposed) a lower surface of the the light emitting layer EML. The light emitting layer EML may be disposed in the light emitting opening OP-PDL and in a portion around the light emitting opening OP-PDL.

The functional layer FNL may control a movement of electric charges. The functional layer FNL may include a hole injection/transport material and/or an electron injection/transport material. The functional layer FNL may include at least one of an electron block layer, a hole transport layer, a hole injection layer, a hole block layer, an electron transport layer, an electron injection layer, and an electric charge generating layer.

The barrier wall conductive layer WCL may be disposed on the pixel definition layer PDL. The barrier wall conductive layer WCL may be disposed between the first light emitting element LD1 and the second light emitting element LD2. The first light emitting element LD1 and the second light emitting element LD2 may be disposed in the areas partitioned by the barrier wall conductive layer WCL shown in FIG. 5. The barrier wall opening WOP defined through the barrier wall conductive layer WCL may be disposed between the first light emitting element LD1 and the second light emitting element LD2.

Openings OP having a size greater than the light emitting openings OP-PDL may be defined through the barrier wall conductive layer WCL to overlap the light emitting openings OP-PDL. The first and second light emitting elements LD1 and LD2 may be respectively disposed in the openings OP. For example, the opening OP in which the third light emitting element LD3 is disposed may be further defined through the barrier wall conductive layer WCL.

Referring to FIGS. 7 and 8, each of the first and second barrier wall conductive layers WCL1 and WCL2 may include a first conductive layer CTL1 disposed on the pixel definition layer PDL, a second conductive layer CTL2 disposed on the first conductive layer CTL1, and a third conductive layer CTL3 disposed on the second conductive layer CTL2. The second conductive layer CTL2 may be disposed between the first conductive layer CTL1 and the third conductive layer CTL3.

The second conductive layer CTL2 may have a thickness greater than the first and third conductive layers CTL1 and CTL3. The second conductive layer CTL2 may have a conductivity higher than the first and third conductive layers CTL1 and CTL3.

The first conductive layer CTL1 and the third conductive layer CTL3 may have the same material as each other. The second conductive layer CTL2 may include a material different from that of the first and third conductive layers CTL1 and CTL3. The first and third conductive layers CTL1 and CTL3 may have an etch rate lower than that of the second conductive layer CTL2. The second conductive layer CTL2 may include aluminum (Al), and the first and third conductive layers CTL1 and CTL3 may include titanium (Ti).

Side surfaces IS of the first and third conductive layers CTL1 and CTL3 may protrude outward more than a side surface IS of the second conductive layer CTL2. The side surface IS of the second conductive layer CTL2 may be placed inside the side surfaces IS of the first and third conductive layers CTL1 and CTL3. Portions of the first and third conductive layers CTL1 and CTL3, which protrude outward more than the side surface IS of the second conductive layer CTL2 may be defined as a tip portion TP.

Side surfaces IS of the barrier wall conductive layer WCL may be defined by the side surfaces IS of the first, second, and third conductive layers CTL1, CTL2, and CTL3. The side surfaces IS of the barrier wall conductive layer WCL may correspond to the first, second, and third inner side surfaces IS1, IS2, and IS3. Areas defined by the first, second, and third inner side surfaces IS1, IS2, and IS3 may be defined as the openings OP. The side surfaces IS of the first, second, and third conductive layers CTL1, CTL2, and CTL3 may be disposed adjacent to the first and second light emitting elements LD1 and LD2.

The functional layer FNL and the second electrode EL2 may extend toward the barrier wall conductive layer WCL and may be in contact with the side surface IS of the barrier wall conductive layer WCL. For example, the functional layer FNL and the second electrode EL2 may be in contact with the side surface IS of the second conductive layer CTL2 after extending along on the pixel definition layer PDL and the first conductive layer CTL1.

As the second electrodes EL2 of the first and second light emitting elements LD1 and LD2 are in contact with the side surfaces IS of the barrier wall conductive layer WCL, the barrier wall conductive layer WCL may be electrically connected to the first and second light emitting elements LD1 and LD2. The first light emitting element LD1 may be connected (e.g., electrically connected) to the side surface IS of the barrier wall conductive layer WCL adjacent to the first light emitting element LD1. The second light emitting element LD2 may be connected (e.g., electrically connected) to the side surface IS of the barrier wall conductive layer WCL adjacent to the second light emitting element LD2.

The barrier wall conductive layer WCL may be divided into portions that are electrically insulated from each other by the barrier wall opening WOP. As the barrier wall conductive layer WCL is divided into portions electrically insulated from each other by the barrier wall opening WOP, the first light emitting element LD1 and the second light emitting element LD2 may be electrically insulated from each other.

The first barrier wall conductive layer WCL1 of the barrier wall conductive layer WCL may be disposed adjacent to the first light emitting element LD1 and may be electrically connected to the first light emitting element LD1. The second barrier wall conductive layer WCL2 of the barrier wall conductive layer WCL may be electrically insulated from the first barrier wall conductive layer WCL1 by the barrier wall opening WOP. The second barrier wall conductive layer WCL2 may be disposed adjacent to the second light emitting element LD2 and may be electrically connected to the second light emitting element LD2.

For example, the third barrier wall conductive layer WCL3 of the barrier wall conductive layer WCL may be electrically insulated from the first and second barrier wall conductive layers WCL1 and WCL2 by the barrier wall opening WOP and may be electrically connected to the third light emitting element LD3.

As shown in FIG. 5, the first barrier wall conductive layer WCL1 may have the closed-loop shape and may surround the first light emitting element LD1 shown in FIG. 7. As shown in FIG. 5, the second barrier wall conductive layer WCL2 may have the closed-loop shape and may surround the second light emitting element LD2 shown in FIG. 7. For example, the third barrier wall conductive layer WCL3 may have the closed-loop shape and may surround the third light emitting element LD3.

The first light emitting element LD1 may be in contact with the side surface IS (or the first inner side surface IS1) of the first barrier wall conductive layer WCL1 surrounding the first light emitting element LD1. For example, the second electrode EL2 of the first light emitting element LD1 may be in contact with the side surface IS (or the first inner side surface IS1) of the first barrier wall conductive layer WCL1 surrounding the second electrode EL2 of the first light emitting element LD1.

The second light emitting element LD2 may be in contact with the side surface IS (or the second inner side surface IS2) of the second barrier wall conductive layer WCL2 surrounding the second light emitting element LD2. For example, the second electrode EL2 of the second light emitting element LD2 may be in contact with the side surface IS (or the second inner side surface IS2) of the second barrier wall conductive layer WCL2 surrounding the second electrode EL2 of the second light emitting element LD2.

The transistor TR may overlap or be disposed below the first barrier wall conductive layer WCL1 and may be electrically connected to the first barrier wall conductive layer WCL1. For example, a third contact hole CH3 may be defined through the pixel definition layer PDL and the sixth and seventh insulating layers 60 and 70, which are disposed between the first barrier wall conductive layer WCL1 and the transistor TR. The first barrier wall conductive layer WCL1 may be connected (e.g., electrically connected) to the drain electrode pattern layer SDP2 of the transistor TR via the third contact hole CH3.

A portion of the first barrier wall conductive layer WCL1, which extends from the first barrier wall conductive layer WCL1 and is disposed in the third contact hole CH3, may be defined as a light emitting connection portion CE. For example, the light emitting connection portion CE may be defined as the portion of the first barrier wall conductive layer WCL1, which overlaps the third contact hole CH3.

The light emitting connection portion CE may be formed by the first conductive layer CTL1 and the second conductive layer CTL2 of the first barrier wall conductive layer WCL1. In plan view, the light emitting connection portion CE may be disposed to overlap the first barrier wall conductive layer WCL1.

The light emitting connection portion CE may correspond to the first, second, and third light emitting connection portions CE1, CE2, and CE3 shown in FIGS. 4 and 5. As FIG. 7 shows the cross-section taken along line I-I' of FIG. 5, the light emitting connection portion CE of FIG. 7 may be the first light emitting connection portion CE1 shown in FIG. 5.

The light emitting connection portion CE may be electrically connected to the transistor TR via the third contact hole CH3. An extension line EXL extending from the driving connection portion CD may be in contact with the light emitting connection portion CE, and thus, the transistor TR may be connected (e.g., electrically connected) to the light emitting connection portion CE.

The extension line EXL may correspond to the first, second, and third extension lines EXL1, EXL2, and EXL3 shown in FIG. 5. As FIG. 7 shows the cross-section taken along line I-I' of FIG. 5, the extension line EXL of FIG. 7 may be the first extension lines EXL1 shown in FIG. 5.

For example, portions of the second and third barrier wall conductive layers WCL2 and WCL3 shown in FIG. 5 may be defined as the second and third light emitting connection portions CE2 and CE3. The second and third barrier wall conductive layers WCL2 and WCL3 may be respectively connected to the sixth transistors T6 of the second and third pixel driving units PC2 and PC3 via the second and third light emitting connection portions CE2 and CE3, the second and third extension lines EXL2 and EXL3, and the second and third driving connection portions CE2 and CE3.

The functional layer FNL and the second electrode EL2 may be further disposed on the barrier wall conductive layer WCL. The functional layer FNL may be disposed between the barrier wall conductive layer WCL and the second electrode EL2. The barrier wall conductive layer WCL may be insulated from the second electrode EL2 by the functional layer FNL.

The thin film encapsulation layer TFE may be disposed on the first and second light emitting elements LD1 and LD2 and the barrier wall conductive layer WCL. The barrier wall opening WOP may be defined through the barrier wall conductive layer WCL, the functional layer FNL, the second electrode EL2, and the thin film encapsulation layer TFE.

For example, the thin film encapsulation layer TFE may include two inorganic layers and an organic layer disposed between the inorganic layers. The inorganic layers may protect the first and second light emitting elements LD1 and LD2 from moisture and oxygen, and the organic layer may protect the first and second light emitting elements LD1 and LD2 from a foreign substance such as dust particles.

The cover insulating layer C-IL may be disposed on the thin film encapsulation layer TFE. The cover insulating layer may be disposed in the barrier wall opening WOP. The cover insulating layer C-IL may cover the barrier wall conductive layer WCL exposed through the barrier wall opening WOP to protect the barrier wall conductive layer WCL from a foreign substance. The first, second, and third conductive layers CTL1, CTL2, and CTL3 may be protected by the cover insulating layer C-IL.

For example, an input sensing unit may be further disposed on the cover insulating layer C-IL to sense a touch event generated by a user.

The barrier wall conductive layer WCL may be omitted, and the pixel definition layer PDL may be further disposed in place of the barrier wall conductive layer WCL. For example, the pixel definition layer PDL may include an organic layer.

In case that the pixel definition layer PDL is used, a separate connection electrode may be disposed between the sixth insulating layer 60 and the seventh insulating layer 70. The connection electrode may extend onto the transistor TR and may be connected (e.g., electrically connected) to the transistor TR. The connection electrode may extend below the second electrode EL2 of the first light emitting element LD1, may overlap the second electrode EL2, and may be connected (e.g., electrically connected) to the second electrode EL2. For example, the connection electrode may overlap a portion of the first light emitting element LD1. In the case where the connection electrode is disposed to overlap the first light emitting element LD1, an aperture ratio of the pixel PXij may decrease.

The first, second, and third light emitting connection portions CE1, CE2, and CE3 may overlap the barrier wall conductive layer WCL and may not overlap the first, second, and third light emitting elements LD1, LD2, and LD3. Accordingly, the aperture ratio of the pixel PXij may be improved.

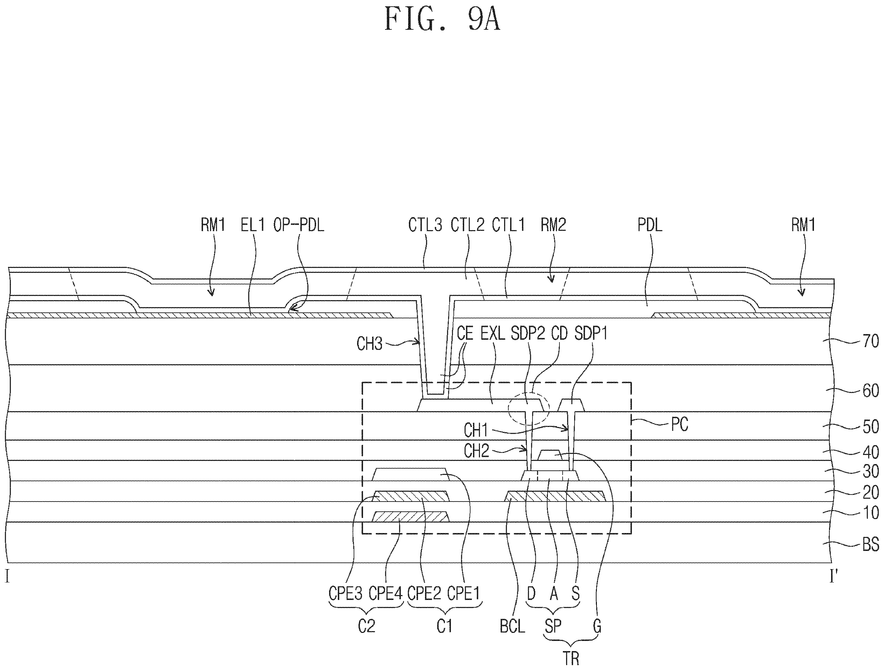

FIGS. 9A to 9G are schematic views illustrating a method of manufacturing the display device.

FIGS. 9A to 9G show cross-sections corresponding to the cross-section shown in FIG. 7 as a representative example.

Referring to FIG. 9A, the pixel driving unit PC may be formed on the base layer BS, and the sixth and seventh insulating layers 60 and 70 may be provided on the pixel driving unit PC. The first electrodes EL1 of the first and second light emitting elements LD1 and LD2 may be provided on the base layer BS. The first electrodes EL1 may be provided on the seventh insulating layer 70. The pixel definition layer PDL through which the light emitting openings OP-PDL are defined may be provided on the first electrodes EL1.

The barrier wall conductive layer WCL may be provided on the first electrodes EL1 and the pixel definition layer PDL. The barrier wall conductive layer WCL may cover the first electrodes EL1 and the pixel definition layer PDL. First removal portions RM1 may be defined through the barrier wall conductive layer WCL, and the first removal portions RM1 may overlap the light emitting openings OP-PDL and may have a size greater than that of the light emitting openings OP-PDL. The first removal portions RM1 may overlap the openings OP.

A second removal portion RM2 may be defined through the barrier wall conductive layer WCL, and the second removal portion RM2 may overlap the barrier wall openings WOP. The second removal portion RM2 may be disposed between the light emitting openings OP-PDL.

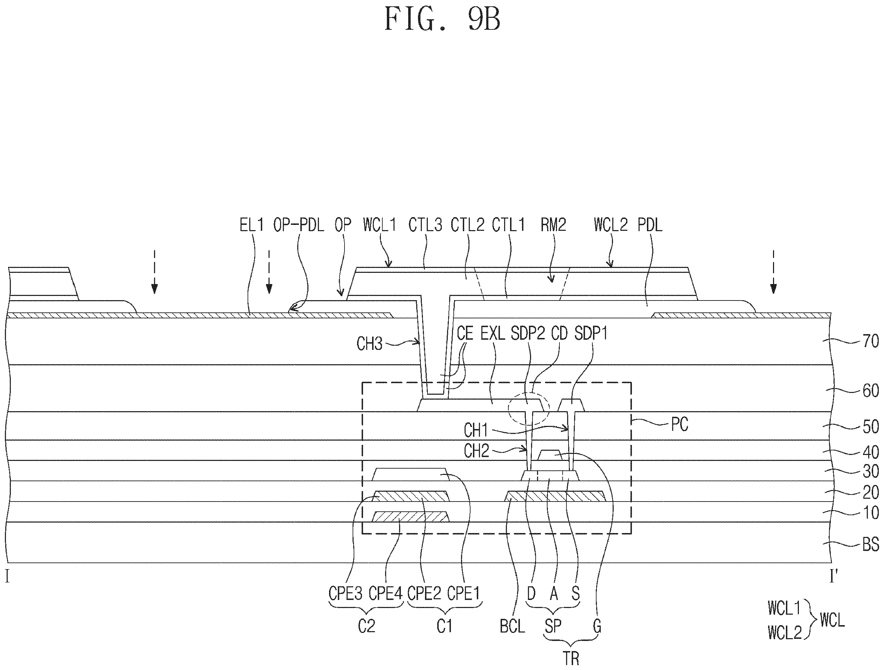

Referring to FIG. 9B, the first removal portions RM1 may be removed from the barrier wall conductive layer WCL. The openings OP may be formed by removing the first removal portions RM1. The first removal portions RM1 may be removed by a dry etching method.

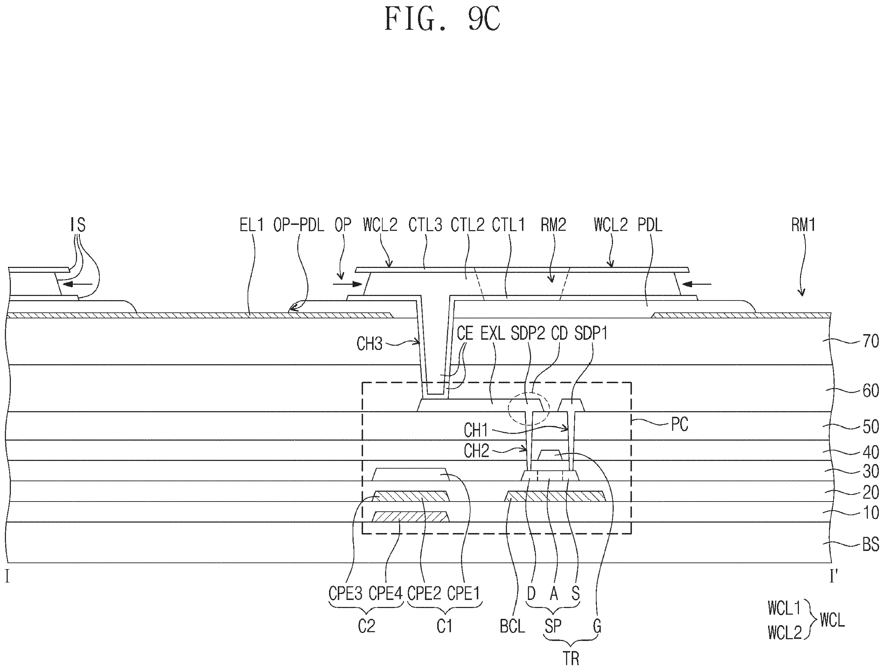

Referring to FIG. 9C, an etchant may be provided to the barrier wall conductive layer WCL via the openings OP. An etching method by using the etchant may be defined as a wet etching method.

Since the second conductive layer CTL2 has an etch rate higher than that of the first and third conductive layers CTL1 and CTL3, the second conductive layer CTL2 may be etched inward more than the first and third conductive layers CTL1 and CTL3. Accordingly, the side surfaces IS of the first and third conductive layers CTL1 and CTL3 may protrude outward more than the side surface IS of the second conductive layer CTL2. The openings OP may be formed by the side surfaces IS of the first and third conductive layers CTL1 and CTL3 and the side surface IS of the second conductive layer CTL2.

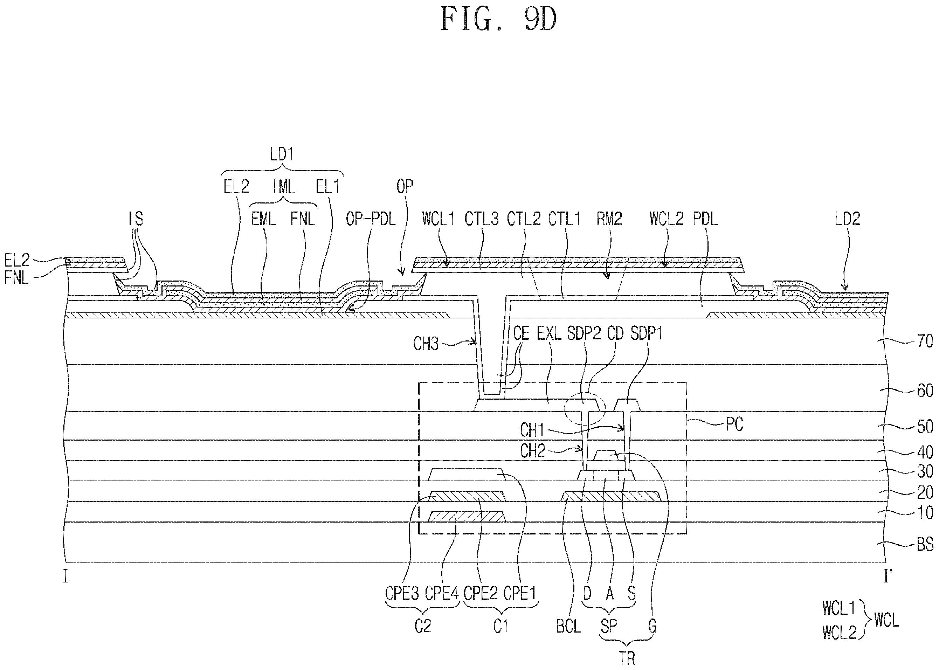

Referring to FIG. 9D, the functional layer FNL, the light emitting layer EML, and the second electrode EL2 may be provided in each of the light emitting openings OP-PDL, and the functional layer FNL and the second electrode EL2 may be provided on the barrier wall conductive layer WCL. The functional layer FNL and the second electrode EL2 may be substantially simultaneously provided in each of the light emitting openings OP-PDL and on the barrier wall conductive layer WCL.

The functional layer FNL and the second electrode EL2 may be provided in each of the openings OP, and the functional layer FNL and the second electrode EL2 may be in contact with the side surface IS of the second conductive layer CTL2 in each of the openings OP.

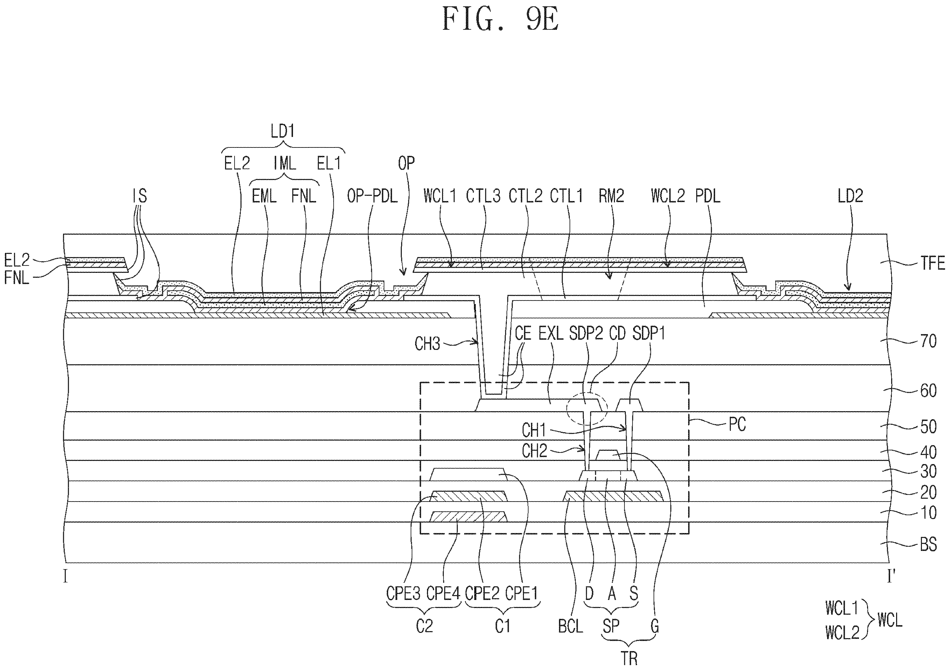

Referring to FIG. 9E, the thin film encapsulation layer TFE may be disposed on the second electrodes EL2.

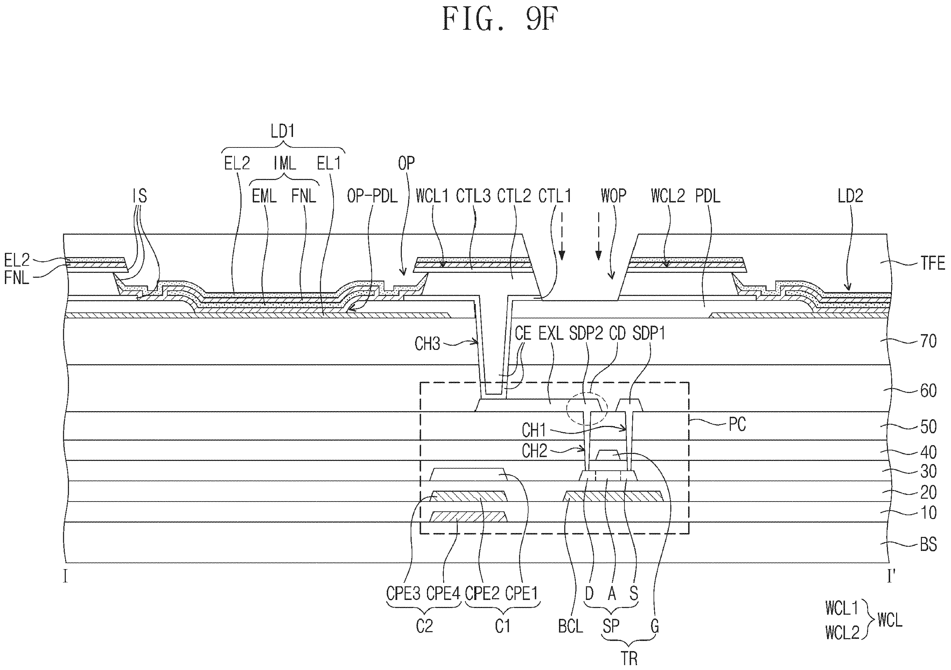

Referring to FIG. 9F, a portion of the thin film encapsulation layer TFE overlapping the second removal portion RM2, a portion of the functional layer FNL overlapping the second removal portion RM2, a portion of the second electrode EL2 overlapping the second removal portion RM2, and the second removal portion RM2 may be removed, and thus, the barrier wall opening WOP may be formed.

The portion of the thin film encapsulation layer TFE overlapping the second removal portion RM2, the portion of the functional layer FNL overlapping the second removal portion RM2, the portion of the second electrode EL2 overlapping the second removal portion RM2, and the second removal portion RM2 may be etched by various etching methods, e.g., the dry etching method, the wet etching method, or the like. According to the process, the functional layer FNL and the second electrode EL2 disposed on the first barrier wall conductive layer WCL1 may be separated from the functional layer FNL and the second electrode EL2 disposed on the second barrier wall conductive layer WCL2 between the first light emitting element LD1 and the second light emitting element LD2.

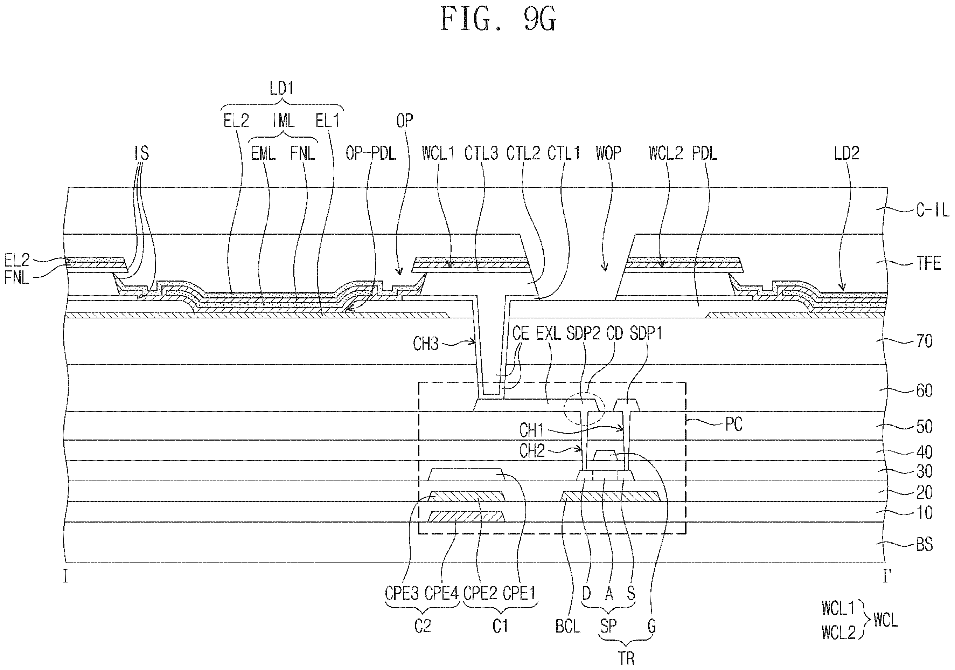

Referring to FIG. 9G, the cover insulating layer C-IL may be disposed on the thin film encapsulation layer TFE. The cover insulating layer C-IL may be provided in the barrier wall opening WOP. The cover insulating layer C-IL may cover the barrier wall conductive layer WCL, the functional layer FNL, and the second electrode EL2, which are exposed through the barrier wall opening WOP.

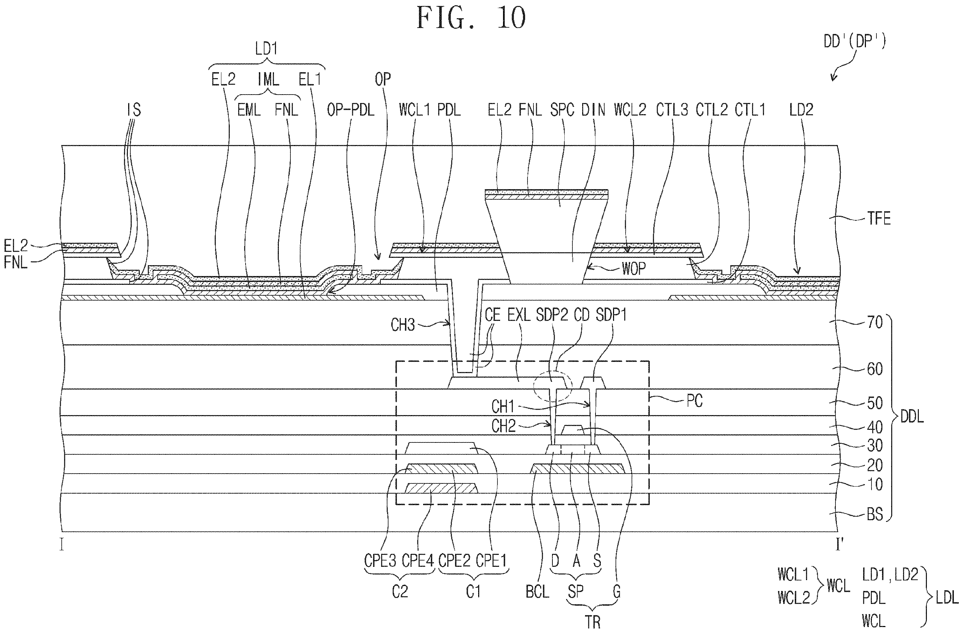

FIG. 10 is a schematic view of a display device DD'.

FIG. 10 shows a cross-section of the display device DD', which corresponds to that of FIG. 7, and hereinafter, components of the display device DD' shown in FIG. 10, which are different from those shown in FIG. 7, will be described.

Referring to FIG. 10, a display panel DP' of the display device DD' may further include a dummy insulating layer DIN disposed in a barrier wall opening WOP and a spacer SPC disposed on the dummy insulating layer DIN. The dummy insulating layer DIN and the spacer SPC may include an organic layer.

The spacer SPC may have a width that increases from a lower surface of the spacer SPC to an upper surface of the spacer. For example, the spacer SPC may have a reverse tapered shape. A functional layer FNL and a second electrode EL2 may be further disposed on the spacer SPC.

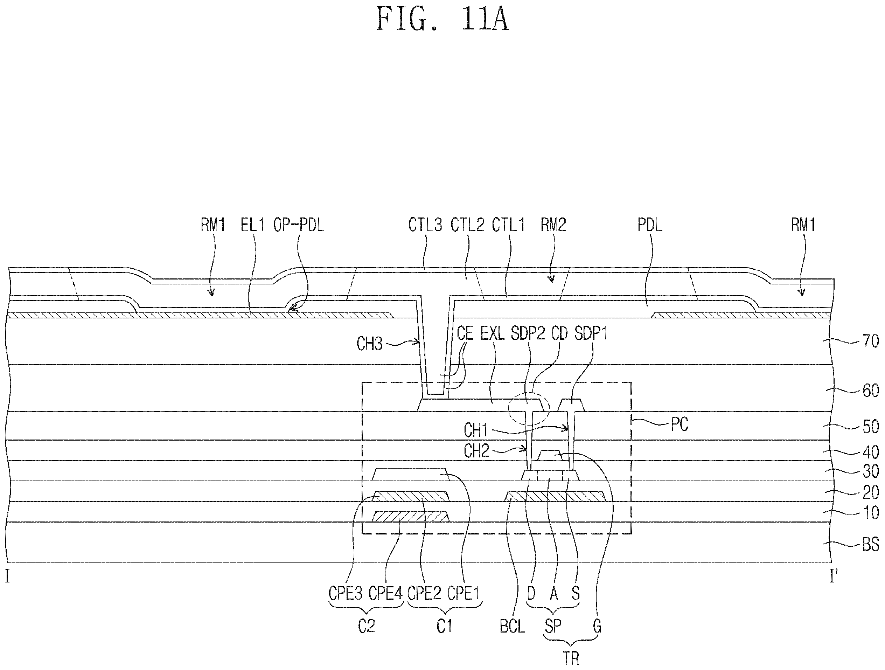

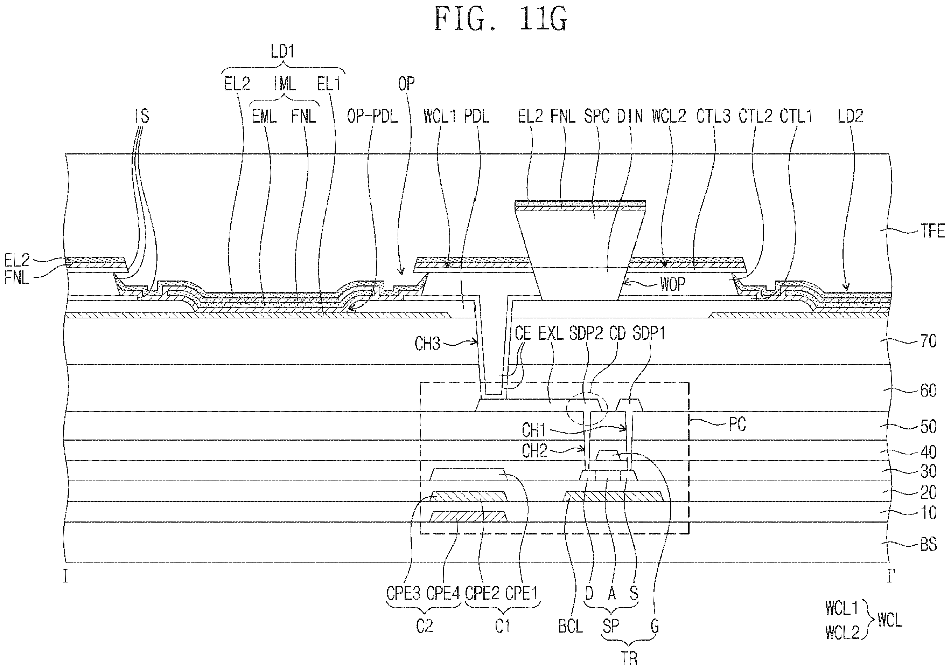

FIGS. 11A to 11G are schematic views illustrating a method of manufacturing the display device DD' shown in FIG. 10.

FIGS. 11A to 11G show cross-sections corresponding to the cross-section shown in FIG. 10. Hereinafter, descriptions of the manufacturing method of the display device DD' will be focused on different features from those of the manufacturing method of the display device DD described with reference to FIGS. 9A to 9G.

Referring to FIG. 11A, first electrodes EL1 may be provided on a base layer BS, and a pixel definition layer PDL through which light emitting openings OP-PDL are defined may be provided on the first electrodes EL1. A barrier wall conductive layer WCL through which first removal portions RM1 and a second removal portion RM2 are defined may be provided on the first electrodes EL1 and the pixel definition layer PDL.

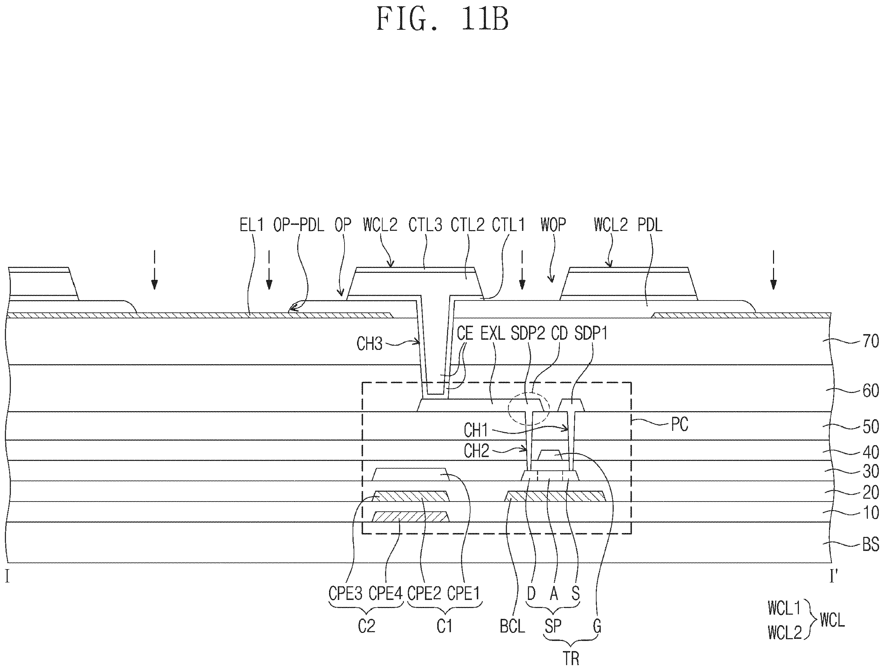

Referring to FIG. 11B, the first removal portions RM1 may be removed from the barrier wall conductive layer WCL to form openings OP, and the second removal portion RM2 may be removed from the barrier wall conductive layer WCL to form the barrier wall opening WOP. The first and second removal portions RM1 and RM2 may be removed by a dry etching method.

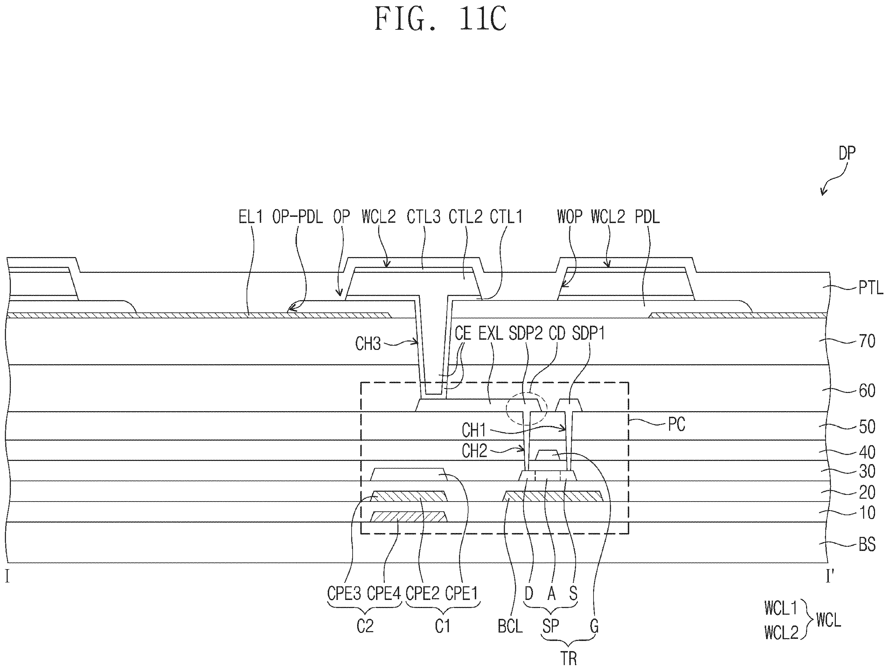

Referring to FIG. 11C, a photo layer PTL including an organic material may be provided on the barrier wall conductive layer WCL. The photo layer PTL may be provided in the openings OP and the barrier wall opening WOP. The photo layer PTL may include photoresist.

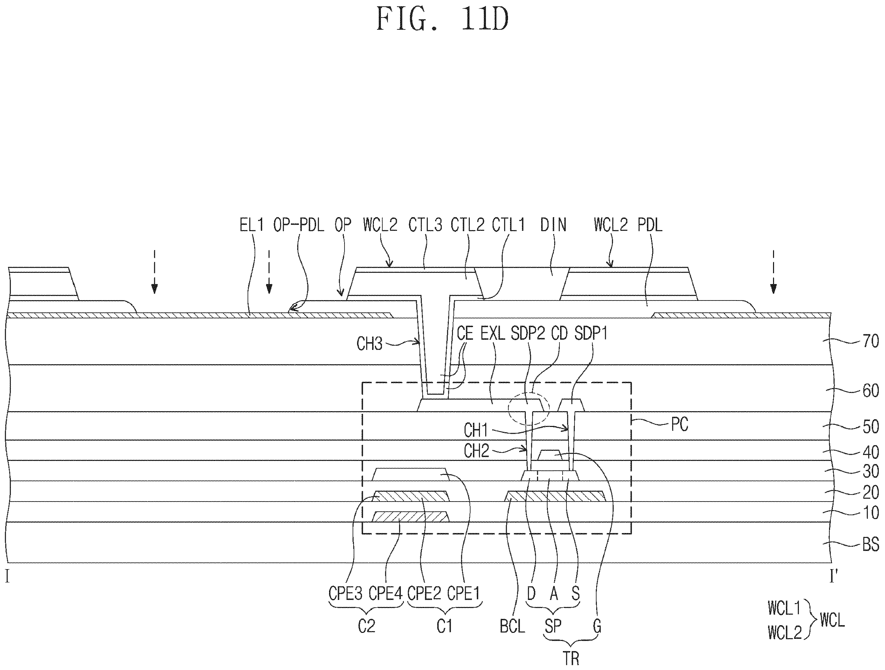

Referring to FIGS. 11C and 11D, a portion of the photo layer PTL, which is disposed in the barrier wall opening WOP, may remain, and the other portion of the photo layer PTL may be removed. As an example, the portion of the photo layer PTL may be removed by exposure and development processes except the portion of the photo layer PTL, which is disposed in the barrier wall opening OP. The dummy insulating layer DIN may be formed by the portion of the photo layer PTL disposed in the barrier wall opening WOP. Accordingly, the dummy insulating layer DIN may be provided in the barrier wall opening WOP.

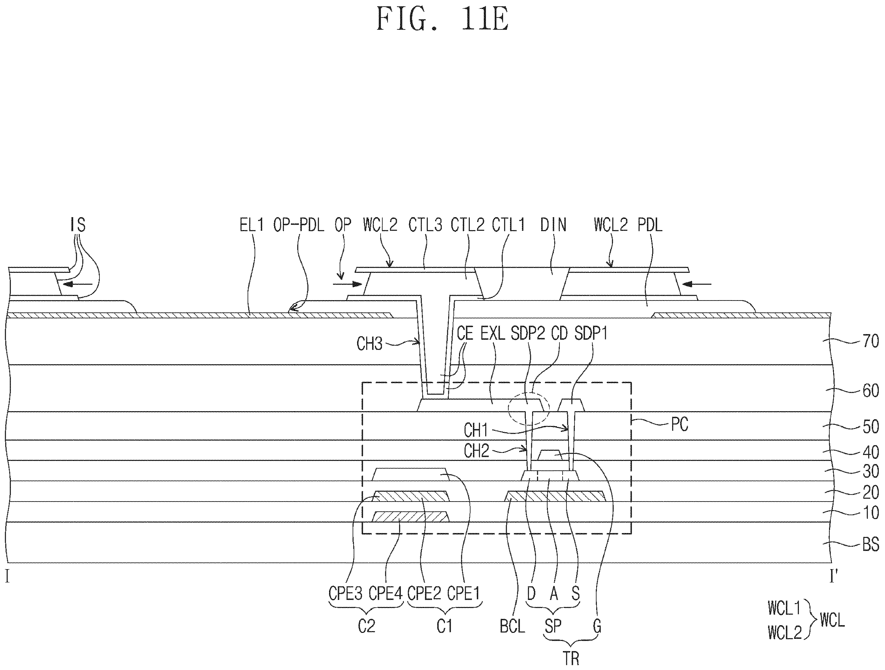

Referring to FIG. 11E, an etchant may be provided to the barrier wall conductive layer WCL via the openings OP, and a second conductive layer CTL2 may be etched inward more than first and third conductive layers CTL1 and CTL3.

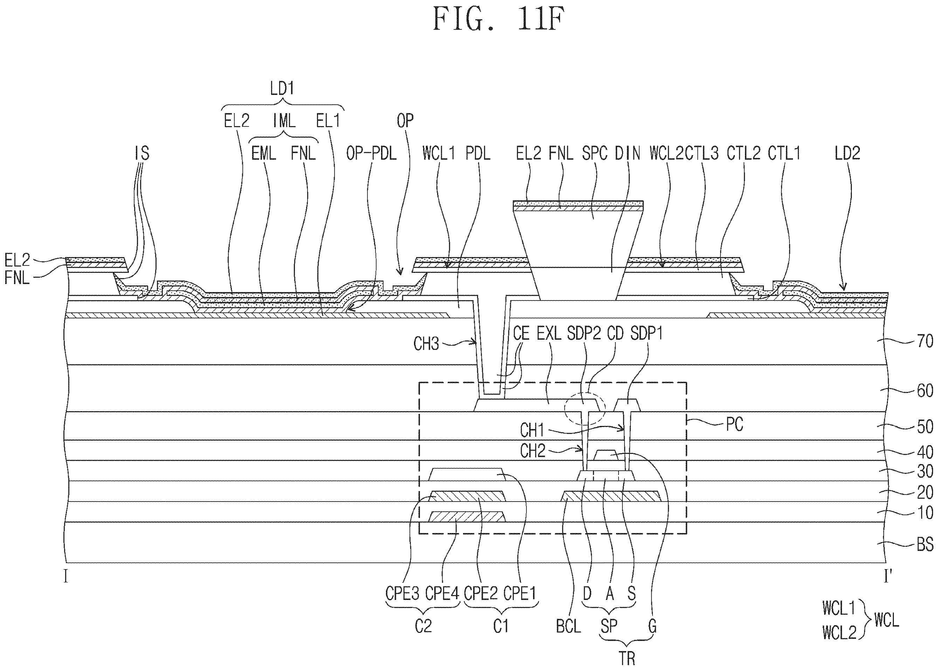

Referring to FIG. 11F, the spacer SPC may be provided on the dummy insulating layer DIN. The functional layer FNL, a light emitting layer EML, and the second electrode EL2 may be provided in each of the light emitting openings OP-PDL, and the functional layer FNL and the second electrode EL2 may be provided on the barrier wall conductive layer WCL. The functional layer FNL and the second electrode EL2 may be provided on the spacer SPC. The functional layer FNL and the second electrode EL2 may be substantially simultaneously provided on the barrier wall conductive layer WCL and the spacer SPC.

Since the spacer SPC has the reverse tapered shape, the functional layer FNL may not be provided on a side surface of the spacer SPC in case that the functional layer FNL is simultaneously deposited on the barrier wall conductive layer WCL and the spacer SPC. For example, since the spacer SPC has the reverse tapered shape, the second electrode EL2 may not be provided on the side surface of the spacer SPC in case that the second electrode EL2 is simultaneously deposited on the barrier wall conductive layer WCL and the spacer SPC.

Accordingly, the functional layer FNL and the second electrode EL2 disposed on a first barrier wall conductive layer WCL1 may be separated from the functional layer FNL and the second electrode EL2 disposed on a second barrier wall conductive layer WCL2 by the spacer SPC between the first light emitting element LD1 and the second light emitting element LD2.

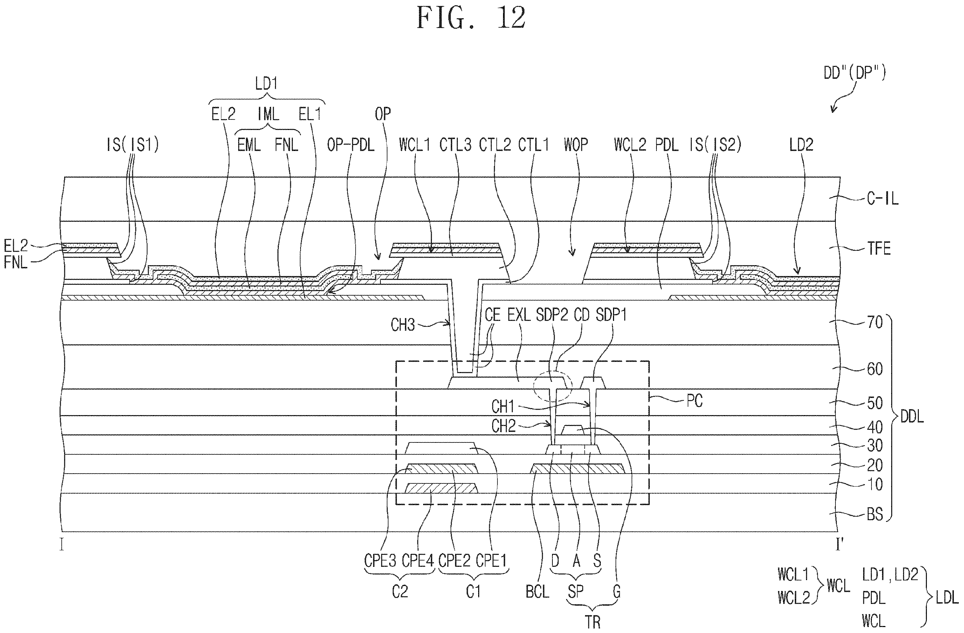

FIG. 12 is a schematic view of a display device DD".

FIG. 12 shows a cross-section of the display device DD", which corresponds to that of FIG. 7, and hereinafter, components of the display device DD" shown in FIG. 12, which are different from those shown in FIG. 7, will be described.

Referring to FIG. 12, a thin film encapsulation layer TFE of a display panel DP" may be disposed on first and second light emitting elements LD1 and LD2 and a barrier wall conductive layer WCL. For example, the thin film encapsulation layer TFE may be disposed on a second electrodes EL2. The thin film encapsulation layer TFE may be disposed in a barrier wall opening WOP. The thin film encapsulation layer TFE may cover first, second, and third conductive layers CTL1, CTL2, and CTL3 of the barrier wall conductive layer WCL, which are exposed through the barrier wall opening WOP, and may protect the first, second, and third conductive layers CTL1, CTL2, and CTL3.

In concluding the detailed description, those skilled in the art will appreciate that many variations and modifications may be made to the embodiments without substantially departing from the scope of the invention as defined by the claims. Therefore, the disclosed embodiments are used in a generic and descriptive sense only and not for purposes of limitation.

## Claims

1. A display device comprising:
a first light emitting element (LD1);
a second light emitting element (LD2); and
a barrier wall conductive layer (WCL) disposed between the first light emitting element and the second light emitting element and electrically connected to the first light emitting element and the second light emitting element, wherein
a barrier wall opening (WOP) is formed through the barrier wall conductive layer, and
the barrier wall opening is disposed between the first light emitting element and the second light emitting element.

2. The display device of claim 1, wherein
the first light emitting element is electrically connected to a side surface of the barrier wall conductive layer adjacent to the first light emitting element, and
the second light emitting element is electrically connected to another side surface of the barrier wall conductive layer adjacent to the second light emitting element.

3. The display device of claim 1 or 2, wherein
the barrier wall conductive layer (WCL) is divided into a plurality of portions by the barrier wall opening, and
the first light emitting element is electrically insulated from the second light emitting element by the plurality of portions of the barrier wall conductive layer.

4. The display device of claim 1, 2 or 3, wherein the barrier wall conductive layer comprises:
a first barrier wall conductive layer (WCL1) adjacent to the first light emitting element and electrically connected to the first light emitting element; and
a second barrier wall conductive layer (WCL2) adjacent to the second light emitting element, electrically connected to the second light emitting element, and electrically insulated from the first barrier wall conductive layer by the barrier wall opening, optionally wherein
the first barrier wall conductive layer has a closed-loop shape and surrounds the first light emitting element, and
the second barrier wall conductive layer has a closed-loop shape and surrounds the second light emitting element.

5. The display device of claim 4, wherein
the first light emitting element is in contact with a first inner side surface of the first barrier wall conductive layer surrounding the first light emitting element, and
the second light emitting element is in contact with a second inner side surface of the second barrier wall conductive layer surrounding the second light emitting element.

6. The display device of claim 4 or 5, further comprising:
a transistor (TR) disposed below the first barrier wall conductive layer and electrically connected to the first barrier wall conductive layer.

7. The display device of claim 6, further comprising:
an insulating layer disposed between the first barrier wall conductive layer and the transistor; and
a light emitting connection portion (CE) disposed in a contact hole formed through a portion of the insulating layer, the light emitting connection portion overlapping the first barrier wall conductive layer in plan view,
wherein the light emitting connection portion extends from the first barrier wall conductive layer and is electrically connected to the transistor via the contact hole.

8. The display device of any one of the preceding claims, further comprising:
a pixel definition layer in which light emitting openings are formed, wherein
the first and second light emitting elements are disposed in the light emitting openings, and
the barrier wall conductive layer is disposed on the pixel definition layer,
optionally wherein the pixel definition layer comprises an inorganic layer.

9. The display device of claim 8, wherein
openings in which the first and second light emitting elements are disposed are formed through the barrier wall conductive layer, and
the openings overlap the light emitting openings and have a size greater than those of the light emitting openings.

10. The display device of claim 8 or 9, wherein
the barrier wall conductive layer comprises:
a first conductive layer disposed on the pixel definition layer;
a second conductive layer disposed on the first conductive layer; and
a third conductive layer disposed on the second conductive layer, and
side surfaces of the first and third conductive layers adjacent to each of the first and second light emitting elements protrude outward more than a side surface of the second conductive layer adjacent to each of the first and second light emitting elements.

11. The display device of claim 10, wherein
the first light emitting element comprises:
a first electrode disposed under the pixel definition layer and partially exposed via a corresponding light emitting opening among the light emitting openings;
a second electrode disposed on the first electrode;
a functional layer disposed between the first electrode and the second electrode; and
a light emitting layer disposed in the functional layer, and
the functional layer and the second electrode are in contact with the side surface of the second conductive layer of the barrier wall conductive layer.

12. The display device of claim 11, wherein
the functional layer and the second electrode are further disposed on the barrier wall conductive layer, and
the barrier wall conductive layer and the second electrode are electrically insulated from each other by the functional layer.

13. The display device of any one of the preceding claims, further comprising:
a thin film encapsulation layer disposed on the first and second light emitting elements and the barrier wall conductive layer,
wherein the barrier wall opening is consecutively formed through the barrier wall conductive layer and the thin film encapsulation layer, the display device optionally further comprising:
a cover insulating layer disposed on the thin film encapsulation layer,
wherein the cover insulating layer is disposed in the barrier wall opening.

14. The display device of any one of the preceding claims, further comprising:
a dummy insulating layer (DIN) disposed in the barrier wall opening, , further comprising:
a spacer (SPC) disposed on the dummy insulating layer (DIN),
wherein the spacer has a width that increases from a lower surface of the spacer to an upper surface of the spacer.

15. The display device of any one of claims 1 to 12, further comprising:
a thin film encapsulation layer disposed on the first and second light emitting elements and the barrier wall conductive layer,
wherein the thin film encapsulation layer is disposed in the barrier wall opening.
